# EUROPEAN PATENT APPLICATION

(11) **EP 4 708 357 A1**
(43) Date of publication of application: **11.03.2026**
(21) Application number: 24800058.0
(22) Date of filing: 15.04.2024
(51) Int. Cl.: H01L 23/28, H01L 23/36, H01L 25/07

(54) **SEMICONDUCTOR DEVICE, METHOD FOR MANUFACTURING SEMICONDUCTOR DEVICE, AND VEHICLE**

(30) Priority: 02.05.2023 JP 2023076218
(71) Applicant: Rohm Co., Ltd., Kyoto-shi, Kyoto 615-8585 (JP)
(72) Inventor: YASUNISHI, Tomohiro, Kyoto-shi, Kyoto 615-8585 (JP); YOSHIDA, Natsuya, Kyoto-shi, Kyoto 615-8585 (JP)
(74) Representative: Witte, Weller & Partner Patentanwälte mbB
(86) International application number: PCT/JP2024/014970
(87) International publication number: WO 2024/228327

(57) **Abstract**

A semiconductor device includes a heat sink, a base material including an insulating layer and mounted on the heat sink on one side in a first direction, a first conductive layer bonded to the base material and located on a side opposite the heat sink with respect to the base material, a first semiconductor element bonded to the first conductive layer, a first power terminal electrically connected to the first conductive layer and the first semiconductor element, and a sealing resin covering the first conductive layer and the first semiconductor element. The first power terminal is exposed from the sealing resin. The first power terminal is surrounded by a peripheral edge of the sealing resin as viewed in the first direction.

## Description

### TECHNICAL FIELD

The present disclosure relates to a semiconductor device, a method of manufacturing the same, and a vehicle on which the semiconductor device is mounted.

### BACKGROUND ART

Conventionally, semiconductor devices including a semiconductor element having a switching function (a MOSFET or an IGBT) have been widely known and have been used mainly for power conversion. Patent Document 1 discloses one example of such a semiconductor device. The semiconductor device disclosed in the document includes a sealing resin (the sealing body in Patent Document 1) covering the semiconductor element, and a heat sink (the heat sink in Patent Document 1). The sealing resin is attached to the heat sink via a screw. This can improve heat dissipation of the semiconductor device.

Here, depending on a use mode, a semiconductor device in which a heat sink and a sealing resin are integrated with each other may be required. In such a semiconductor device, work for attaching the sealing resin to the heat sink is not required. However, if an attempt is made to adopt a structure in which the heat sink and the sealing resin are integrated with each other in the semiconductor device disclosed in Patent Document 1, a power lead projecting from a side surface of the sealing resin interferes with a molding die, which may cause deterioration of a molded state of the sealing resin.

### PRIOR ART DOCUMENT

### Patent document

Patent Document 1: WO-2019/239997-A1

### SUMMARY OF THE INVENTION

### Problem to be solved by the Invention

The present disclosure aims to provide an improved semiconductor device and an improved method of manufacturing the same. In view of the circumstances described above, the present disclosure particularly aims to provide a semiconductor device and a method of manufacturing the same, which enable a better molded state of the sealing resin in the semiconductor device in which the heat sink and the sealing resin are integrated with each other.

### Means for Solving the Problems

In accordance with a first aspect of the present disclosure, there is provided a semiconductor device including: a heat sink; a base material mounted on the heat sink on one side in a first direction, the base material including an insulating layer; a conductive layer bonded to the base material and located on a side opposite the heat sink with respect to the base material; a semiconductor element bonded to the conductive layer; a power terminal electrically connected to each of the conductive layer and the semiconductor element; and a sealing resin covering the conductive layer and the semiconductor element. The power terminal is exposed from the sealing resin. The power terminal is surrounded by a peripheral edge of the sealing resin as viewed in the first direction.

In accordance with a second aspect of the present disclosure, there is provided a method of manufacturing a semiconductor device including: a first step of bonding a conductive layer to a base material on one side in a first direction, the base material including an insulating layer; a second step of bonding the base material to a heat sink located on a side opposite the conductive layer with respect to the base material; a third step of disposing a power terminal on the base material and bonding a semiconductor element to the conductive layer; and a fourth step of forming a sealing resin to cover the conductive layer and the semiconductor element. The fourth step is performed after completion of each of the first, second, and third steps. In the fourth step, the power terminal is left exposed from the sealing resin, the power terminal being surrounded by a peripheral edge of the sealing resin as viewed in the first direction.

In accordance with a third aspect of the present disclosure, there is provided a vehicle including a driving source and a semiconductor device. The semiconductor device further includes a signal terminal with respect to the semiconductor device according to the first aspect. The base material of the semiconductor device includes a metal layer. The metal layer is bonded to an obverse surface of the heat sink of the semiconductor device. The heat sink includes a base portion including the obverse surface, and a heat radiating portion connected to the base portion. The heat radiating portion projects from the base portion on a side opposite the obverse surface in the first direction.

### Advantages of the Invention

According to the above configuration, it is possible to improve a molded state of the sealing resin in a semiconductor device in which a heat sink and the sealing resin are integrated with each other.

Other features and advantages of the present disclosure will be more apparent from the detailed description given below with reference to the attached drawings.

### BRIEF DESCRIPTION OF THE DRAWINGS

FIG. 1 is a perspective view of a semiconductor device according to a first embodiment of the present disclosure.
FIG. 2 is a plan view of the semiconductor device shown in FIG. 1.
FIG. 3 is a right-side view of the semiconductor device shown in FIG. 1.
FIG. 4 is a front view of the semiconductor device shown in FIG. 1.
FIG. 5 is a back view of the semiconductor device shown in FIG. 1.
FIG. 6 is a bottom view of the semiconductor device shown in FIG. 1.
FIG. 7 is a plan view corresponding to FIG. 2, with a sealing resin being transparent and a heat sink omitted.
FIG. 8 is a plan view corresponding to FIG. 2, with a sealing resin being transparent and a second conductive member and a heat sink omitted.
FIG. 9 is a plan view corresponding to FIG. 2, with a sealing resin being transparent and a first conductive member, a second conductive member and a heat sink omitted.
FIG. 10 is a cross-sectional view taken along line X-X of FIG. 7.
FIG. 11 is a cross-sectional view taken along line XI-XI of FIG. 7.
FIG. 12 is a partially enlarged view of a first semiconductor element and its vicinity shown in FIG. 11.
FIG. 13 is a partially enlarged view of a second semiconductor element and its vicinity shown in FIG. 11.
FIG. 14 is a cross-sectional view taken along line XIV-XIV of FIG. 7.
FIG. 15 is a cross-sectional view taken along line XV-XV of FIG. 7.
FIG. 16 is a partially enlarged view of FIG. 10.
FIG. 17 is a partially enlarged cross-sectional view of a semiconductor device according to a variation of the first embodiment of the present disclosure.
FIG. 18 is a cross-sectional view for explaining a manufacturing step of the semiconductor device shown in FIG. 1.
FIG. 19 is a cross-sectional view for explaining a manufacturing step of the semiconductor device shown in FIG. 1.
FIG. 20 is a cross-sectional view for explaining a manufacturing step of the semiconductor device shown in FIG. 1.
FIG. 21 is a schematic view of a vehicle on which the semiconductor device shown in FIG. 1 is mounted.
FIG. 22 is a plan view of a semiconductor device according to a second embodiment of the present disclosure.
FIG. 23 is a cross-sectional view of the semiconductor device shown in FIG. 22, corresponding to FIG. 10.
FIG. 24 is a cross-sectional view of the semiconductor device shown in FIG. 22, corresponding to FIG. 11.
FIG. 25 is a partially enlarged view of FIG. 24.
FIG. 26 is a plan view of a semiconductor device according to a third embodiment of the present disclosure.
FIG. 27 is a cross-sectional view of the semiconductor device shown in FIG. 26, corresponding to FIG. 11.
FIG. 28 is a cross-sectional view of the semiconductor device shown in FIG. 26, corresponding to FIG. 14.

### MODE FOR CARRYING OUT THE INVENTION

Embodiments of the present disclosure will be described with reference to the accompanying drawings.

### First embodiment:

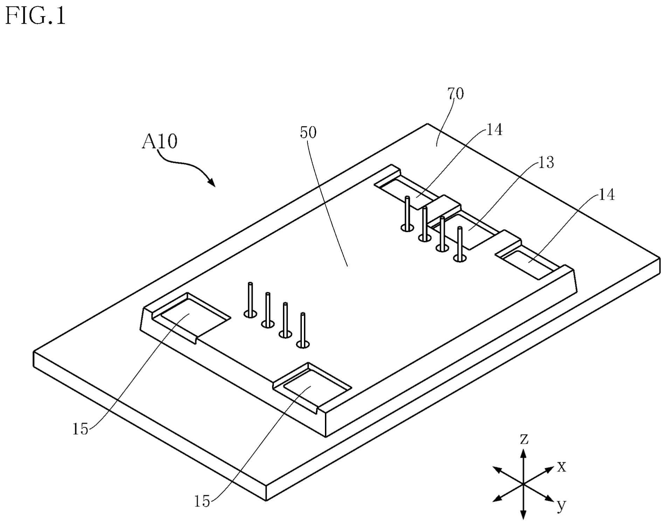

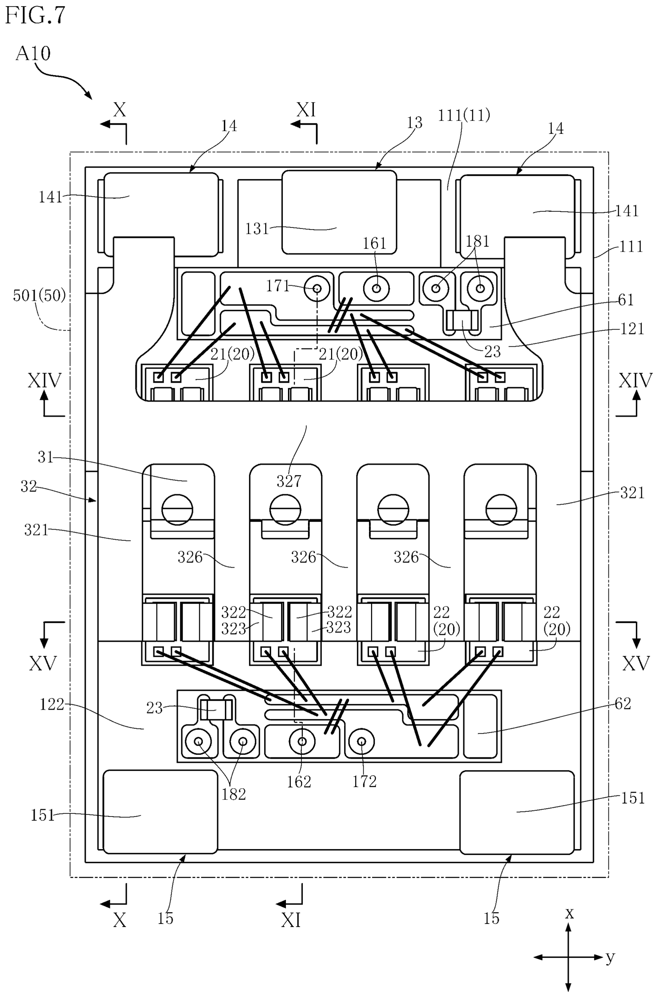

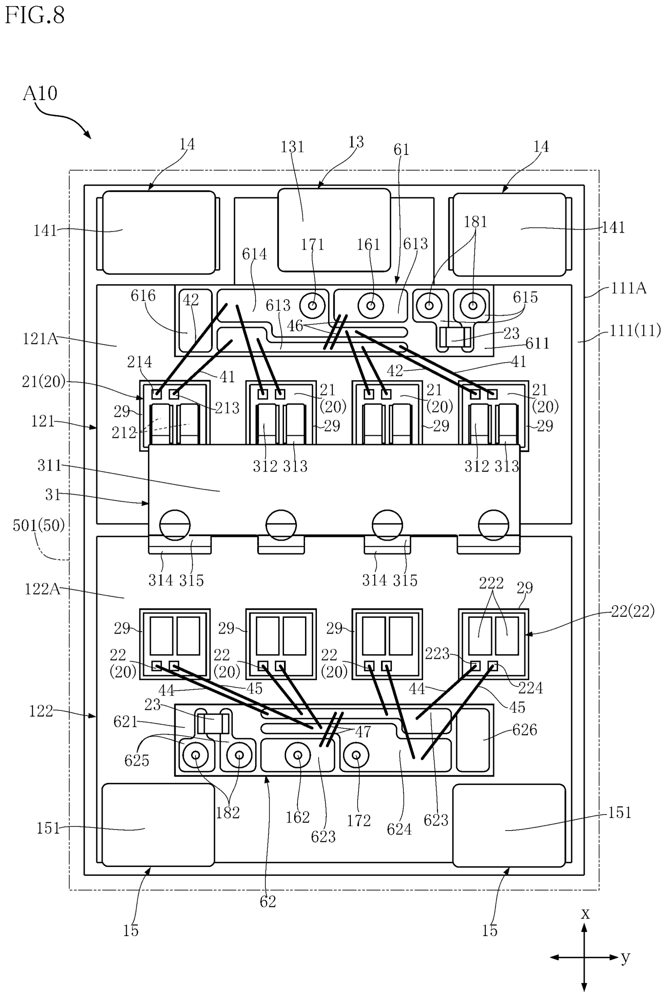

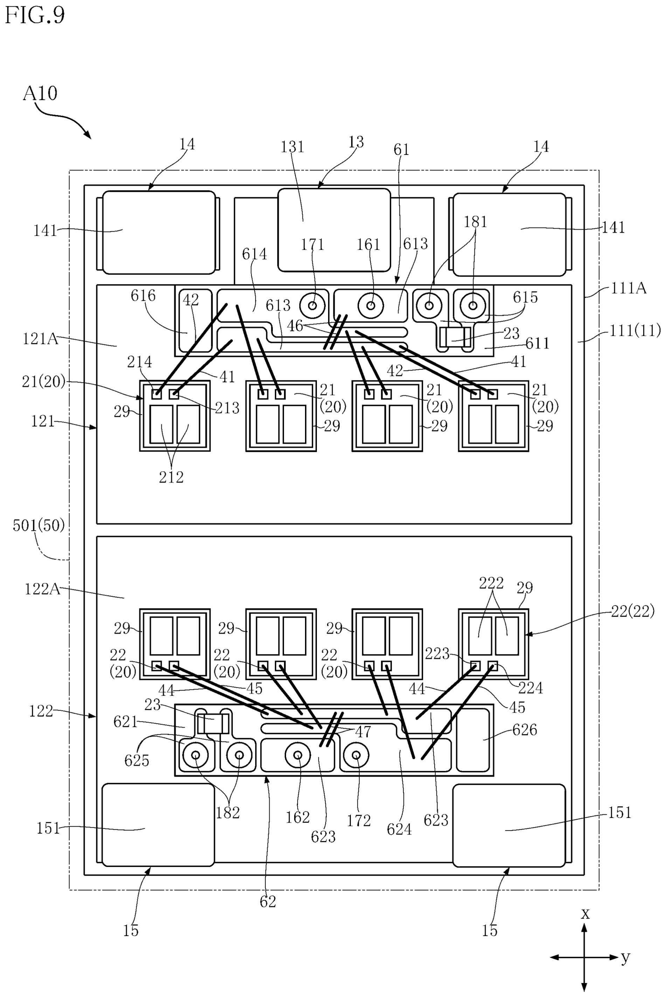

With reference to FIGS. 1 to 16, a semiconductor device A10 according to a first embodiment of the present disclosure will be described. The semiconductor device A10 includes a base material 11, a first bonding layer 19, a first conductive layer 121, a second conductive layer 122, a first power terminal 13, two second power terminals 14, two third power terminals 15, a plurality of semiconductor elements 20, one or more second bonding layers 29, a first conductive member 31, a second conductive member 32, a sealing resin 50, and a heat sink 70. The semiconductor device A10 further includes a first signal terminal 161, a second signal terminal 162, a third signal terminal 171, a fourth signal terminal 172, two fifth signal terminals 181, two sixth signal terminals 182, two thermistors 23, one or more third bonding layers 39, a first wiring 61, and a second wiring 62. In FIGS. 7 to 9, for the sake of understanding, the sealing resin 50 is transparent and illustration of the heat sink 70 is omitted. In FIGS. 7 to 9, the transparent sealing resin 50 is represented by an imaginary line (chain double-dashed line). In FIG. 8, for the sake of understanding, illustration of the second conductive member 32 is further omitted. In FIG. 9, for the sake of understanding, illustration of the first conductive member 31 and the second conductive member 32 is further omitted.

In the description of the semiconductor device A10, for convenience, a normal direction of an obverse surface 711 of the heat sink 70 described later is referred to as a "first direction z". One direction orthogonal to the first direction z is referred to as a "second direction x". A direction orthogonal to the first direction z and the second direction x is referred to as a "third direction y".

The semiconductor device A10 converts DC power input to the first power terminal 13 and the two second power terminals 14 into AC power through the semiconductor elements 20. The converted AC power is supplied from each of the two third power terminals 15 to a power supply target such as a motor.

The heat sink 70 serves to cool the semiconductor device A10. The heat sink 70 contains metal. For example, the heat sink 70 is made of a material containing aluminum (Al).

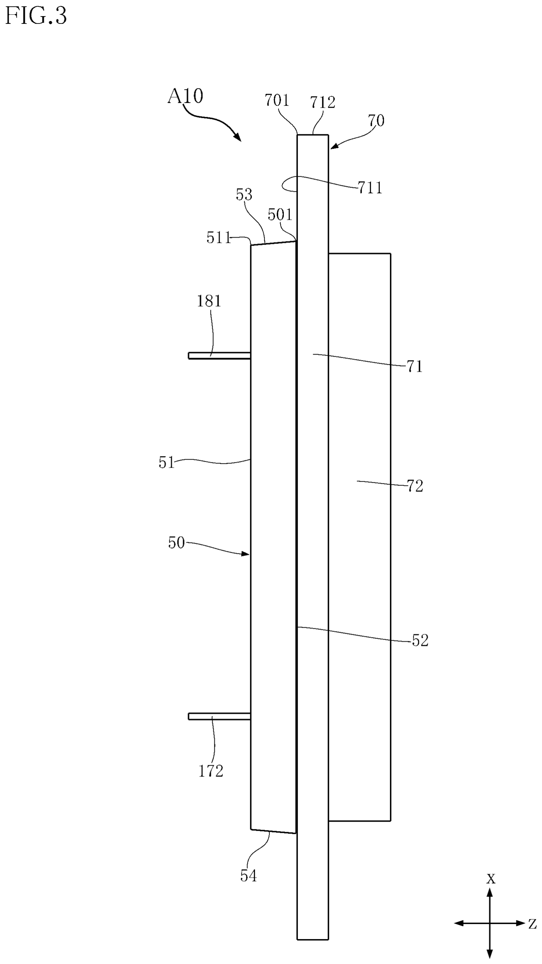

As shown in FIGS. 3 to 5, the heat sink 70 includes a base portion 71, an obverse surface 711, a plurality of end surfaces 712, and a heat radiating portion 72. The base portion 71 is plate-shaped. The obverse surface 711 and the end surfaces 712 are provided on the base portion 71. The obverse surface 711 faces one side in the first direction z. The obverse surface 711 is partially exposed from the sealing resin 50. Each of the end surfaces 712 faces a direction orthogonal to the first direction z. Each of the end surfaces 712 is exposed from the sealing resin 50.

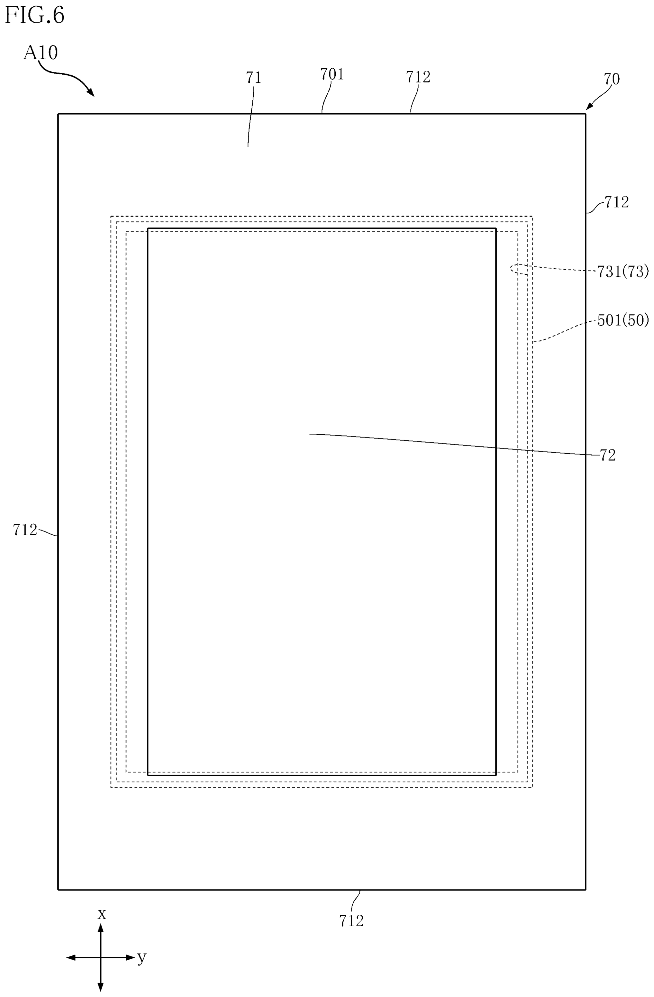

As shown in FIGS. 3 to 5, the heat radiating portion 72 is connected to the base portion 71. The heat radiating portion 72 projects from the base portion 71 on a side opposite the obverse surface 711 in the first direction z. In the semiconductor device A10, the heat radiating portion 72 has a rectangular shape. Alternatively, the heat radiating portion 72 may be configured from a plurality of fins arranged in a direction orthogonal to the first direction z. As shown in FIG. 6, the heat radiating portion 72 is located inward of a peripheral edge 501 of the sealing resin 50 as viewed in the first direction z.

As shown in FIGS. 6, 10, 11, 14 and 15, the base portion 71 of the heat sink 70 is provided with an engagement portion 73 on the obverse surface 711. The sealing resin 50 is in contact with the engagement portion 73.

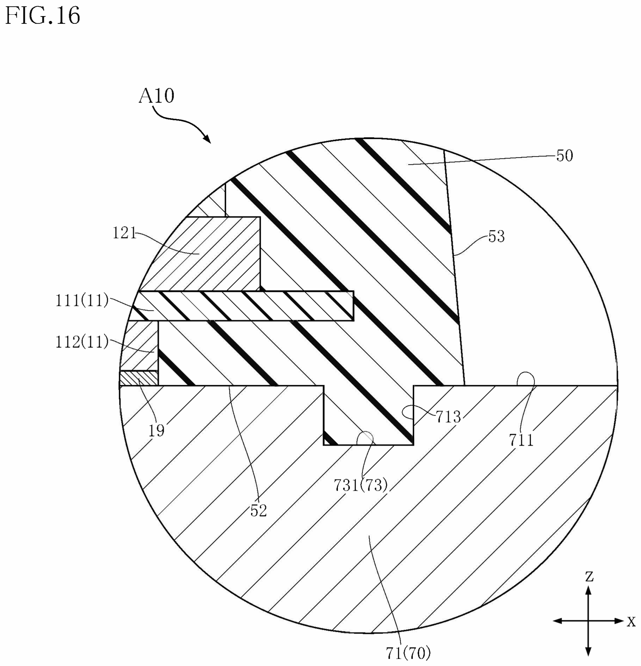

As shown in FIG. 16, in the semiconductor device A10, the engagement portion 73 includes a recess 731 recessed from the obverse surface 711. The heat sink 70 includes an inner circumferential surface 713 connected to the obverse surface 711, and the inner circumferential surface 713 defines the engagement portion 73. The inner circumferential surface 713 is provided in the base portion 71. The sealing resin 50 is in contact with the inner circumferential surface 713.

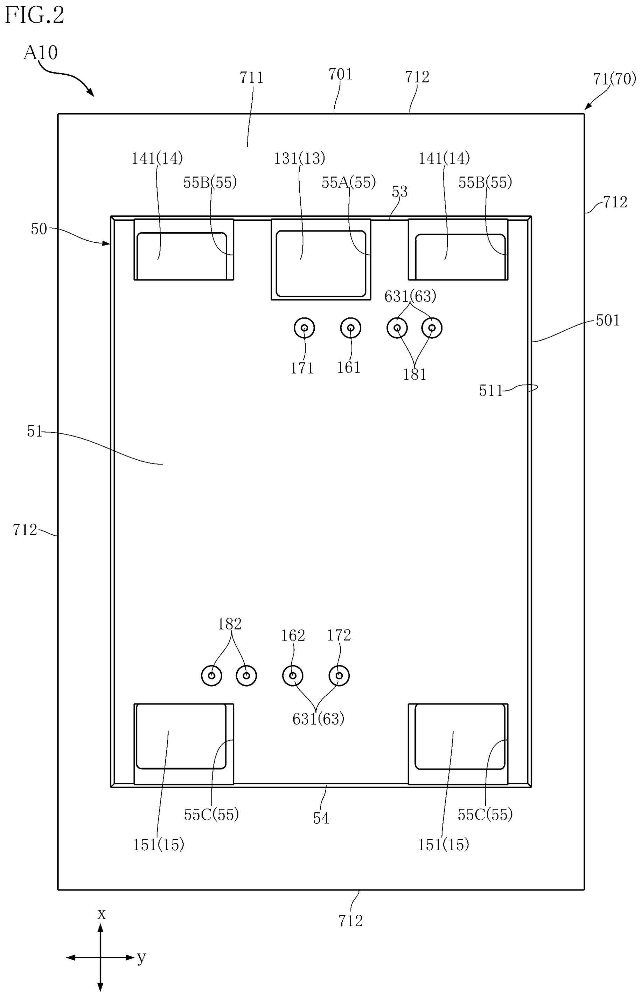

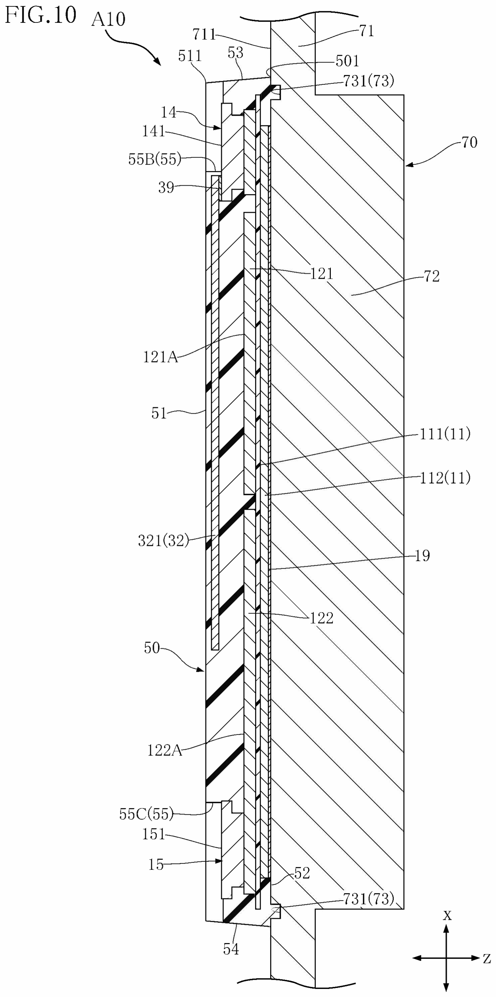

As shown in FIGS. 10, 11, 14 and 15, the sealing resin 50 covers the base material 11, the first conductive layer 121, the second conductive layer 122, the semiconductor elements 20, the first conductive member 31, and the second conductive member 32. Further, the sealing resin 50 covers a part of each of the first power terminal 13, the third power terminal 15, and the second power terminal 14. The sealing resin 50 has electrical insulation properties. For example, the sealing resin 50 is made of a material containing black epoxy resin. As shown in FIG. 2, as viewed in the first direction z, the sealing resin 50 is located inward of a peripheral edge 701 of the heat sink 70. As shown in FIGS. 3 to 5, the sealing resin 50 includes a top surface 51, a bottom surface 52, a first side surface 53, a second side surface 54, and a plurality of recesses 55.

As shown in FIGS. 10, 11, 14 and 15, in the first direction z, the top surface 51 faces a side on which the first conductive layer 121 and the second conductive layer 122 are located with respect to the base material 11. That is, the top surface 51 faces the same side as the obverse surface 711 of the heat sink 70 in the first direction z. The bottom surface 52 faces away from the top surface 51 in the first direction z. As shown in FIGS. 10, 11, 14 and 15, the bottom surface 52 is in contact with the obverse surface 711.

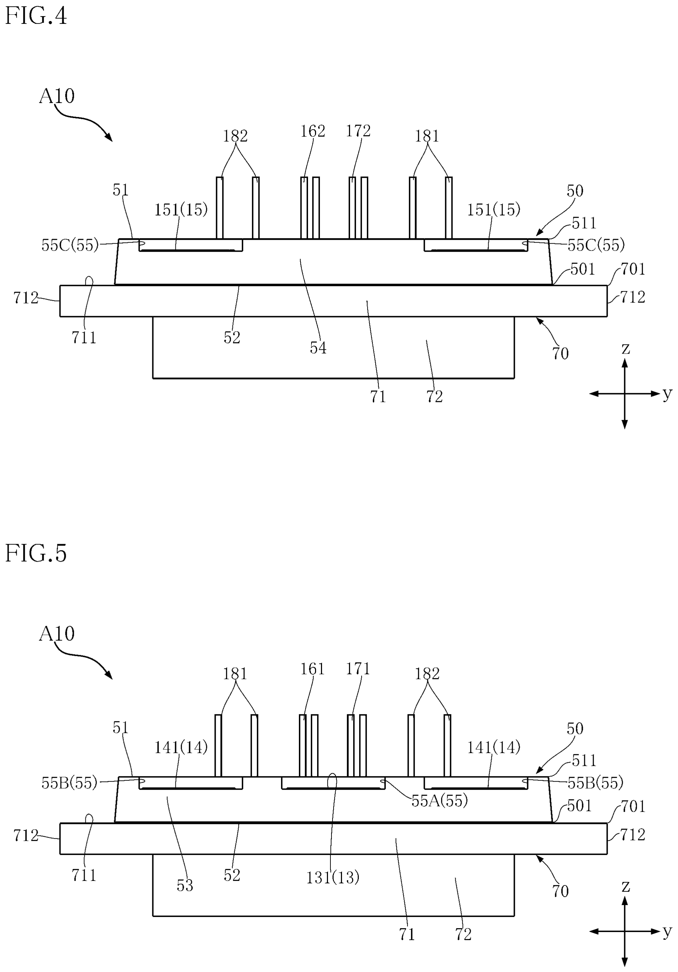

As shown in FIGS. 3 and 4, the first side surface 53 and the second side surface 54 are spaced apart from each other in the second direction x. The first side surface 53 and the second side surface 54 face away from each other in the second direction x.

As shown in FIGS. 2, 4 and 5, each of the recesses 55 is recessed from the top surface 51 and from a corresponding one of the first side surface 53 and the second side surface 54. The recesses 55 include a first recess 55A, two second recesses 55B, and two third recesses 55C. Each of the first recess 55A and the two second recesses 55B is connected to the first side surface 53. In the third direction y, the first recess 55A is located between the two second recesses 55B. The two third recesses 55C are connected to the second side surface 54. The two third recesses 55C are spaced apart from each other in the third direction y.

As shown in FIGS. 10, 11, 14 and 15, the base material 11 is mounted on the heat sink 70 on one side in the first direction z. In the semiconductor device A10, the base material 11 is, for example, configured from a DBC (Direct Bonded Copper) substrate. The base material 11 includes an insulating layer 111 and a metal layer 112. Each of the insulating layer 111 and the metal layer 112 is covered with the sealing resin 50.

As shown in FIGS. 10, 11, 14 and 15, the metal layer 112 is bonded to the obverse surface 711 of the heat sink 70. The metal layer 112 contains copper (Cu). As viewed in the first direction z, the metal layer 112 is located inward of a peripheral edge 111A of the insulating layer 111.

As shown in FIGS. 10, 11, 14 and 15, the first bonding layer 19 bonds the metal layer 112 and the obverse surface 711 of the heat sink 70. The first bonding layer 19 is covered with the sealing resin 50. The first bonding layer 19 is solder or a sintered body of metal particles containing, for example, silver. Alternatively, the first bonding layer 19 may be a minute metal layer formed at the bonding interface through solid-state diffusion. A glass transition temperature of the sealing resin 50 is lower than a melting point of the first bonding layer 19.

As shown in FIGS. 10, 11, 14 and 15, the insulating layer 111 is located on a side opposite the first bonding layer 19 with respect to the metal layer 112. The insulating layer 111 is laminated on the metal layer 112. The insulating layer 111 is made of a material exhibiting relatively high thermal conductivity. For example, the insulating layer 111 is made of a ceramic containing aluminum nitride (AlN). The insulating layer 111 may be configured from an insulating resin sheet instead of ceramics.

As shown in FIGS. 10, 11, 14 and 15, the first conductive layer 121 and the second conductive layer 122 are located on a side opposite the heat sink 70 with respect to the base material 11. Each of the first conductive layer 121 and the second conductive layer 122 is bonded to the insulating layer 111 of the base material 11. As shown in FIGS. 8 and 9, the first conductive layer 121 and the second conductive layer 122 are located inward of the peripheral edge 111A of the insulating layer 111. Each of the first conductive layer 121 and the second conductive layer 122 contains copper. The first conductive layer 121 and the second conductive layer 122 are spaced apart from each other in the second direction x. A dimension of each of the first conductive layer 121 and the second conductive layer 122 in the first direction z is greater than a dimension of the insulating layer 111 in the first direction z. The first conductive layer 121 includes a first mounting surface 121A facing the same side as the obverse surface 711 of the heat sink 70 in the first direction z. The first mounting surface 121A faces the semiconductor elements 20. The second conductive layer 122 includes a second mounting surface 122A facing the same side as the first mounting surface 121A in the first direction z.

As shown in FIGS. 7 to 9, each of the semiconductor elements 20 is mounted on a corresponding one of the first conductive layer 121 and the second conductive layer 122. The semiconductor elements 20 are, for example, Metal-Oxide-Semiconductor Field-Effect Transistors (MOSFETs). Alternatively, the semiconductor elements 20 may be switching elements such as Insulated Gate Bipolar Transistors (IGBTs) or diodes. In the description of the semiconductor device A10, each of the semiconductor elements 20 is an n-channel type MOSFET of vertical structure. The semiconductor elements 20 include a compound semiconductor substrate. The compound semiconductor substrate includes silicon carbide (SiC).

As shown in FIG. 9, in the semiconductor device A10, the semiconductor elements 20 include a plurality of first semiconductor elements 21 and a plurality of second semiconductor elements 22. A structure of each of the second semiconductor elements 22 is the same as a structure of each of the first semiconductor elements 21. The first semiconductor elements 21 are mounted on the first mounting surface 121A of the first conductive layer 121. The first semiconductor elements 21 are arranged along the third direction y. The second semiconductor elements 22 are mounted on the second mounting surface 122A of the second conductive layer 122. The second semiconductor elements 22 are arranged along the third direction y.

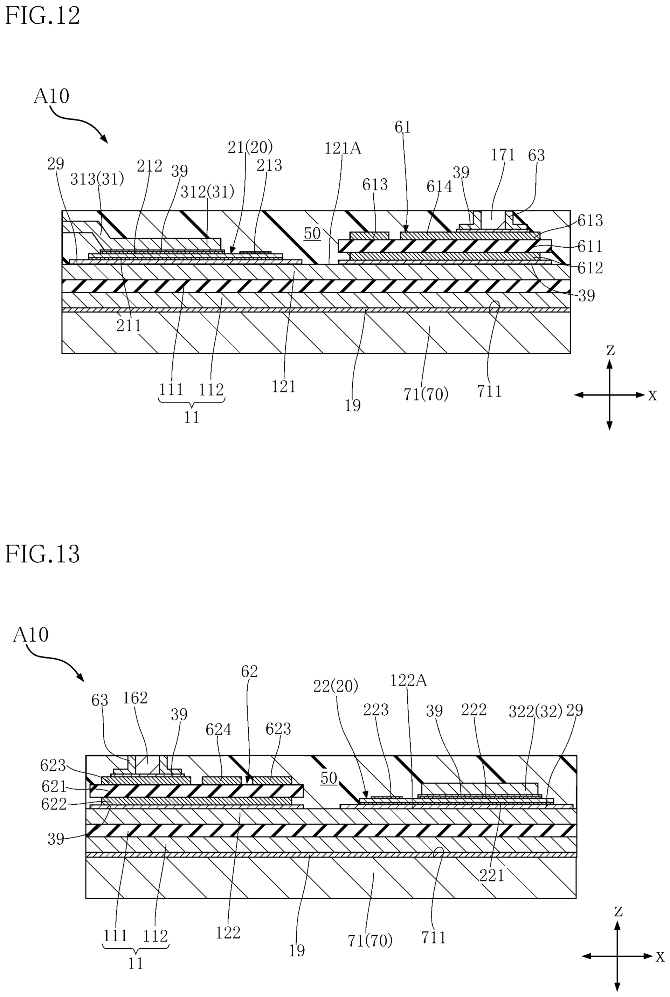

As shown in FIGS. 9 and 12, each of the first semiconductor elements 21 includes a first electrode 211, a second electrode 212, a first gate electrode 213, and a first detection electrode 214.

As shown in FIG. 12, the first electrode 211 faces the first mounting surface 121A of the first conductive layer 121. The first electrode 211 conducts a current corresponding to power before conversion by the relevant first semiconductor element 21. In other words, the first electrode 211 corresponds to a drain electrode of the relevant first semiconductor element 21.

As shown in FIG. 12, a second bonding layer 29 electrically bonds the first mounting surface 121A of the first conductive layer 121 and a corresponding one of first electrode 211 of the first semiconductor element 21. Accordingly, the first electrode 211 of each first semiconductor element 21 is electrically connected to the first conductive layer 121. Second bonding layer 29 is solder or a sintered body of metal particles containing, for example, silver. Alternatively, second bonding layer 29 may be a minute metal layer formed at the bonding interface through solid-state diffusion. A glass transition temperature of the sealing resin 50 is lower than a melting point of second bonding layer 29.

As shown in FIG. 12, the second electrode 212 is located on a side opposite the first mounting surface 121A of the first conductive layer 121 in the first direction z. Accordingly, the first electrode 211 and the second electrode 212 are located away from each other in the first direction z. The second electrode 212 conducts a current corresponding to power after conversion by the relevant first semiconductor element 21. That is, the second electrode 212 corresponds to a source electrode of the relevant first semiconductor element 21.

As shown in FIG. 12, the first gate electrode 213 is located on a side opposite the first mounting surface 121A of the first conductive layer 121 in the first direction z. Accordingly, the first gate electrode 213 is located on the same side as the second electrode 212 in the first direction z. The first gate electrode 213 receives a gate voltage for driving the relevant first semiconductor element 21. As shown in FIG. 9, as viewed in the first direction z, an area of the first gate electrode 213 is smaller than an area of the second electrode 212.

As shown in FIG. 9, the first detection electrode 214 is located on the same side as the second electrode 212 and the first gate electrode 213 in the first direction z. The first detection electrode 214 is adjacent to the relevant first gate electrode 213 in the third direction y. The first detection electrode 214 receives a voltage equivalent to a voltage applied to the second electrode 212. As viewed in the first direction z, an area of the first detection electrode 214 is substantially equal to an area of the first gate electrode 213.

As shown in FIGS. 9 and 13, each of second semiconductor elements 22 includes a third electrode 221, a fourth electrode 222, a second gate electrode 223, and a second detection electrode 224.

As shown in FIG. 13, the third electrode 221 faces the second mounting surface 122A of the second conductive layer 122. The third electrode 221 conducts a current corresponding to power before conversion by the relevant second semiconductor element 22. In other words, the third electrode 221 corresponds to a drain electrode of the relevant second semiconductor element 22. The third electrode 221 is electrically bonded to the second mounting surface 122A via a corresponding one of the second bonding layers 29. Accordingly, the third electrode 221 of each of the second semiconductor elements 22 is electrically connected to the second conductive layer 122.

As shown in FIG. 13, the fourth electrode 222 is located on a side opposite the second mounting surface 122A of the second conductive layer 122 in the first direction z. Accordingly, the third electrode 221 and the fourth electrode 222 are located away from each other in the first direction z. The fourth electrode 222 conducts a current corresponding to power after conversion by the relevant second semiconductor element 22. In other words, the fourth electrode 222 corresponds to a source electrode of the relevant second semiconductor element 22.

As shown in FIG. 13, the second gate electrode 223 is located on a side opposite the second mounting surface 122A of the second conductive layer 122 in the first direction z. Accordingly, the second gate electrode 223 is located on the same side as the fourth electrode 222 in the first direction z. The second gate electrode 223 receives a gate voltage for driving the relevant second semiconductor element 22. As shown in FIG. 9, as viewed in the first direction z, an area of the second gate electrode 223 is smaller than an area of the fourth electrode 222.

As shown in FIG. 9, the second detection electrode 224 is located on the same side as the fourth electrode 222 and the second gate electrode 223 in the first direction z. Two second detection electrode 224 is adjacent to the second gate electrode 223 in the third direction y. The second detection electrode 224 receives a voltage equivalent to a voltage applied to the fourth electrode 222. As viewed in the first direction z, an area of the second detection electrode 224 is substantially equal to an area of the second gate electrode 223.

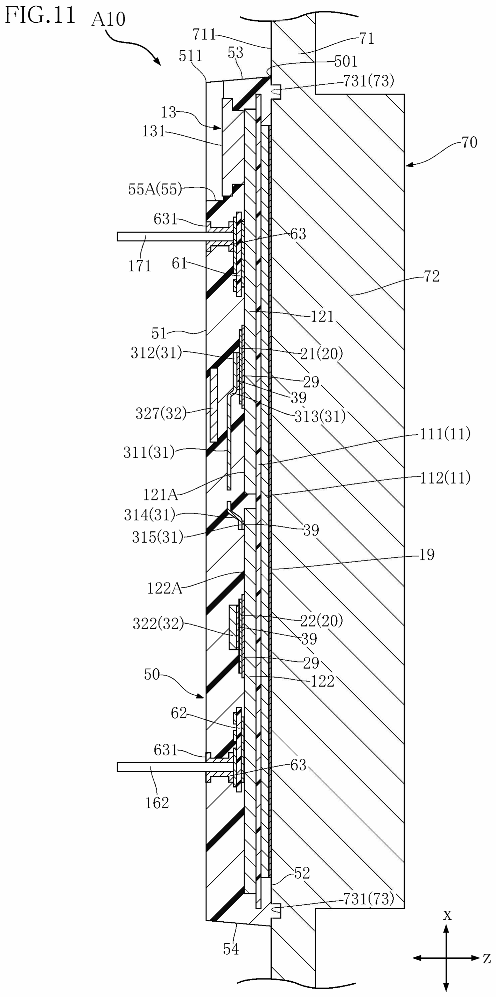

As shown in FIG. 9, the first power terminal 13 is located on a side opposite the second semiconductor elements 22 with respect to the first semiconductor elements 21 in the second direction x. The first power terminal 13 is disposed on the base material 11. The first power terminal 13 is electrically bonded to the first conductive layer 121. Accordingly, the first power terminal 13 is electrically connected to the first electrode 211 of each of the first semiconductor elements 21 via the first conductive layer 121. The first power terminal 13 serves as a P terminal (positive electrode) to which DC power to be converted is input. As shown in FIG. 2, the first power terminal 13 is exposed from the top surface 51 of the sealing resin 50. As viewed in the first direction z, the first power terminal 13 is surrounded by the peripheral edge 501 of the sealing resin 50 and is located inward of the peripheral edge 511 of the top surface 51. As shown in FIG. 11, the first power terminal 13 includes a first connection surface 131 exposed from the sealing resin 50. The first connection surface 131 faces the same side as the obverse surface 711 of the heat sink 70 in the first direction z. As shown in FIGS. 5 and 11, in the semiconductor device A10, the first connection surface 131 is received in the first recess 55A among the recesses 55 of the sealing resin 50.

As shown in FIG. 9, each of the two second power terminals 14 is located on the same side as the first power terminal 13 with respect to the first semiconductor elements 21 in the second direction x. The two second power terminals 14 are disposed on the base material 11. Each of the two second power terminals 14 is bonded to the insulating layer 111 of the base material 11. Each of the two second power terminals 14 is electrically connected to the fourth electrode 222 of each of the second semiconductor elements 22. The two second power terminals 14 serve as N terminals (negative electrodes) to which DC power to be converted is input. The two second power terminals 14 are spaced apart from each other in the third direction y. The first power terminal 13 is located between the two second power terminals 14 in the third direction y. As shown in FIG. 2, each of the two second power terminals 14 is exposed from the top surface 51 of the sealing resin 50. As viewed in the first direction z, each of the two second power terminals 14 is surrounded by the peripheral edge 501 of the sealing resin 50, and is located inward of the peripheral edge 511 of the top surface 51. As shown in FIG. 10, each of the two second power terminals 14 includes a second connection surface 141 exposed from the sealing resin 50. Each second connection surface 141 faces the same side as the obverse surface 711 of the heat sink 70 in the first direction z. As shown in FIGS. 5 and 10, in the semiconductor device A10, the two second connection surfaces 141 are received individually in the respective two second recesses 55B among the recesses 55 of the sealing resin 50.

As shown in FIG. 9, each of the two third power terminals 15 is located on a side opposite the first power terminal 13 and the two second power terminals 14 with respect to the semiconductor elements 20 in the second direction x. The two third power terminals 15 are disposed on the base material 11. Each of the two third power terminals 15 is electrically bonded to the second conductive layer 122. Accordingly, each of the two third power terminals 15 is electrically connected to the third electrode 221 of each of the second semiconductor elements 22 via the second conductive layer 122. From each of the two third power terminals 15, AC power converted by the semiconductor elements 20 is output. In the semiconductor device A10, the two third power terminals 15 are spaced apart from each other in the third direction y. As shown in FIG. 2, each of the two third power terminals 15 is exposed from the top surface 51 of the sealing resin 50. As viewed in the first direction z, each of the two third power terminals 15 is surrounded by the peripheral edge 501 of the sealing resin 50, and is located inward of the peripheral edge 511 of the top surface 51. As shown in FIG. 10, each of the two third power terminals 15 includes a third connection surface 151 exposed from the sealing resin 50. Each third connection surface 151 faces the same side as the obverse surface 711 of the heat sink 70 in the first direction z. As shown in FIGS. 4 and 10, in the semiconductor device A10, the two third connection surfaces 151 are received individually in the respective two third recesses 55C among the recesses 55 of the sealing resin 50.

As shown in FIG. 12, the first wiring 61 is bonded to the first mounting surface 121A of the first conductive layer 121. In the second direction x, the first wiring 61 is located on a side opposite the second semiconductor elements 22 with respect to the first semiconductor elements 21. The first wiring 61 is electrically connected to the first semiconductor elements 21 and to the first conductive layer 121. As shown in FIGS. 9 and 12, the first wiring 61 includes a first mounting layer 611, a first metal layer 612, two first gate wiring layers 613, a first detection wiring layer 614, a first temperature detection wiring layer 615, and a second detection wiring layer 616.

As shown in FIG. 9, the first mounting layer 611 carries the two first gate wiring layers 613, the first detection wiring layer 614, the two first temperature detection wiring layers 615, and the second detection wiring layer 616. The first mounting layer 611 is an insulator. The first mounting layer 611 is made of, for example, ceramics. Alternatively, the first mounting layer 611 may be configured from an insulating resin sheet.

As shown in FIG. 12, the first metal layer 612 is located between the first mounting layer 611 and the first mounting surface 121A of the first conductive layer 121 in the first direction z. The first metal layer 612 is bonded to the first mounting layer 611. The first metal layer 612 contains copper. The first metal layer 612 is bonded to the first mounting surface 121A via a corresponding one of third bonding layers 39. Each third bonding layer 39 is solder, for example.

As shown in FIGS. 9 and 12, the two first gate wiring layers 613 are located on a side opposite the first metal layer 612 with respect to the first mounting layer 611. The two first gate wiring layers 613 are bonded to the first mounting layer 611. Among the two first gate wiring layers 613, a plurality of first wires 41 are electrically bonded to one first gate wiring layer 613. The first wires 41 are electrically bonded to the respective first gate electrodes 213 of the first semiconductor elements 21. Further, a plurality of sixth wires 46 are electrically bonded to each of the two first gate wiring layers 613. Accordingly, each of the two first gate wiring layers 613 is electrically connected to the first gate electrode 213 of each of the first semiconductor elements 21.

As shown in FIGS. 9 and 12, the first detection wiring layer 614 is located on a side opposite the first metal layer 612 with respect to the first mounting layer 611. The first detection wiring layer 614 is bonded to the first mounting layer 611. A plurality of second wires 42 are electrically bonded to the first detection wiring layer 614. Further, the second wires 42 are electrically bonded to the respective first detection electrodes 214 of the first semiconductor elements 21. Accordingly, the first detection wiring layer 614 is electrically connected to the first detection electrode 214 of each of the first semiconductor elements 21.

As shown in FIG. 9, the two first temperature detection wiring layers 615 are located on a side opposite the first metal layer 612 with respect to the first mounting layer 611. The two first temperature detection wiring layers 615 are bonded to the first mounting layer 611. The two first temperature detection wiring layers 615 are adjacent to each other in the third direction y.

As shown in FIG. 9, the second detection wiring layer 616 is located on a side opposite the first metal layer 612 with respect to the first mounting layer 611. The second detection wiring layer 616 is bonded to the first mounting layer 611.

As shown in FIG. 13, the second wiring 62 is bonded to the second mounting surface 122A of the second conductive layer 122. In the second direction x, the second wiring 62 is located on a side opposite the first semiconductor elements 21 with respect to the second semiconductor elements 22. The second wiring 62 is electrically connected to the second semiconductor elements 22 and to the second conductive layer 122. As shown in FIGS. 9 and 13, the second wiring 62 includes a second mounting layer 621, a second metal layer 622, two second gate wiring layers 623, a third detection wiring layer 624, two second temperature detection wiring layers 625, and a fourth detection wiring layer 626.

As shown in FIG. 9, the second mounting layer 621 carries the two second gate wiring layers 623, the third detection wiring layer 624, the two second temperature detection wiring layers 625, and the fourth detection wiring layer 626. The second mounting layer 621 is an insulator. The second mounting layer 621 is made of, for example, ceramics. Alternatively, the second mounting layer 621 may be configured from an insulating resin sheet.

As shown in FIG. 13, the second metal layer 622 is located between the second mounting layer 621 and the second mounting surface 122A of the second conductive layer 122 in the first direction z. The second metal layer 622 is bonded to the second mounting layer 621. The second metal layer 622 contains copper. The second metal layer 622 is bonded to the second mounting surface 122A via a corresponding one of the third bonding layers 39.

As shown in FIGS. 9 and 13, the two second gate wiring layers 623 are located on a side opposite the second metal layer 622 with respect to the second mounting layer 621. The two second gate wiring layers 623 are bonded to the second mounting layer 621. Among the two second gate wiring layers 623, a plurality of fourth wires 44 are electrically bonded to one second gate wiring layer 623. The fourth wires 44 are electrically bonded to the respective second gate electrodes 223 of the second semiconductor elements 22. Further, a plurality of seventh wires 47 are electrically bonded to each of the two second gate wiring layers 623. Accordingly, each of the two second gate wiring layers 623 is electrically connected to the second gate electrode 223 of each of the second semiconductor elements 22.

As shown in FIGS. 9 and 13, the third detection wiring layer 624 is located on a side opposite the second metal layer 622 with respect to the second mounting layer 621. The third detection wiring layer 624 is bonded to the second mounting layer 621. A plurality of fifth wires 45 are electrically bonded to the third detection wiring layer 624. Further, the fifth wires 45 are electrically bonded to the respective second detection electrodes 224 of the second semiconductor elements 22. Accordingly, the third detection wiring layer 624 is electrically connected to the second detection electrode 224 of each of the second semiconductor elements 22.

As shown in FIG. 9, the two second temperature detection wiring layers 625 are located on a side opposite the second metal layer 622 with respect to the second mounting layer 621. The two second temperature detection wiring layers 625 are bonded to the second mounting layer 621. The two second temperature detection wiring layers 625 are adjacent to each other in the third direction y.

As shown in FIG. 9, the fourth detection wiring layer 626 is located on a side opposite the second metal layer 622 with respect to the second mounting layer 621. The fourth detection wiring layer 626 is bonded to the second mounting layer 621.

As shown in FIGS. 12 and 13, each of a plurality of sleeves 63 is electrically bonded to either the first wiring 61 or the second wiring 62 via a corresponding one of third bonding layer 39. Each third bonding layer 39 is solder, for example. The sleeves 63 are each made of a conductive material such as metal. Each of the sleeves 63 has a tubular shape extending in the first direction z. As shown in FIGS. 2 and 11, each of the sleeves 63 includes an end surface 631 facing the same side as the first mounting surface 121A of the first conductive layer 121 in the first direction z. The end surface 631 is exposed from the top surface 51 of the sealing resin 50.

As shown in FIGS. 8 and 9, among the two thermistors 23, one thermistor 23 is electrically bonded to the two first temperature detection wiring layers 615 of the first wiring 61. As shown in FIGS. 8 and 9, the other thermistor 23 is electrically bonded to the two second temperature detection wiring layers 625 of the second wiring 62. The two thermistors 23 serve as sensors for temperature detection of the semiconductor device A10.

As shown in FIG. 3, the first signal terminal 161, the second signal terminal 162, the third signal terminal 171, the fourth signal terminal 172, the two fifth signal terminals 181, and the two sixth signal terminals 182 are each configured from a metal pin extending in the first direction z. These terminals project from the top surface 51 of the sealing resin 50. Further, these terminals are press-fitted individually into the sleeves 63. Hence, each of these terminals is supported by a corresponding one of the sleeves 63 and is electrically connected to either the first wiring 61 or the second wiring 62.

As shown in FIG. 9, the first signal terminal 161 is press-fitted into a one of the sleeves 63 that is electrically bonded to one of the two first gate wiring layers 613 of the first wiring 61. Accordingly, the first signal terminal 161 is electrically connected to the first gate electrode 213 of each of the first semiconductor elements 21 via the two first gate wiring layer 613. The first signal terminal 161 receives a gate voltage for driving the first semiconductor elements 21.

As shown in FIGS. 9 and 11, the second signal terminal 162 is press-fitted into one of the sleeves 63 that is electrically bonded to one of the two second gate wiring layers 623 of the second wiring 62. Accordingly, the second signal terminal 162 is electrically connected to the second gate electrode 223 of each of the second semiconductor elements 22 via the two second gate wiring layer 623. The second signal terminal 162 receives a gate voltage for driving the second semiconductor elements 22.

As shown in FIG. 2, the third signal terminal 171 is located adjacent to the first signal terminal 161 in the third direction y. As shown in FIGS. 9 and 11, the third signal terminal 171 is press-fitted into one of the sleeves 63 that is electrically bonded to the first detection wiring layer 614 of the first wiring 61. Accordingly, the third signal terminal 171 is electrically connected to the first detection electrode 214 of each of the first semiconductor elements 21 via the first detection wiring layer 614. The third signal terminal 171 receives a voltage equivalent to a voltage applied to the first detection electrode 214 of each of the first semiconductor elements 21.

As shown in FIG. 2, the fourth signal terminal 172 is located adjacent to the second signal terminal 162 in the third direction y. As shown in FIG. 9, the fourth signal terminal 172 is press-fitted into one of the sleeves 63 that is electrically bonded to the third detection wiring layer 624 of the second wiring 62. Accordingly, the fourth signal terminal 172 is electrically connected to the second detection electrode 224 of each of the second semiconductor elements 22 via the third detection wiring layer 624. The fourth signal terminal 172 receives a voltage equivalent to a voltage applied to the second detection electrode 224 of each of the second semiconductor elements 22.

As shown in FIG. 2, the two fifth signal terminals 181 are located on a side opposite the third signal terminal 171 with respect to the first signal terminal 161 in the third direction y. The two fifth signal terminals 181 are adjacent to each other in the third direction y. As shown in FIG. 9, the two fifth signal terminals 181 are press-fitted individually into two sleeves 63 that are electrically bonded to the respective two first temperature detection wiring layers 615 of the first wiring 61. Accordingly, the two fifth signal terminals 181 are electrically connected to one of the two thermistors 23 that is electrically bonded to the two first temperature detection wiring layers 615.

As shown in FIG. 2, the two sixth signal terminals 182 are located on a side opposite the fourth signal terminal 172 with respect to the second signal terminal 162 in the third direction y. The two sixth signal terminals 182 are adjacent to each other in the third direction y. As shown in FIG. 9, the two sixth signal terminals 182 are press-fitted individually into two sleeves 63 that are electrically bonded to the respective two second temperature detection wiring layers 625 of the second wiring 62. Accordingly, the two sixth signal terminals 182 are electrically connected to one of the two thermistors 23 that is electrically bonded to the two second temperature detection wiring layers 625.

As shown in FIGS. 8 and 12, the first conductive member 31 is electrically bonded to the second electrodes 212 of the first semiconductor elements 21 and to the second mounting surface 122A of the second conductive layer 122. Accordingly, the second electrodes 212 of the first semiconductor elements 21 are electrically connected to the second conductive layer 122. The first conductive member 31 contains copper. The first conductive member 31 is a metal clip. As shown in FIG. 5, the first conductive member 31 includes a body portion 311, a plurality of first bonding portions 312, a plurality of first coupling portions 313, a second bonding portion 314, and a second coupling portion 315.

The body portion 311 constitutes a main part of the first conductive member 31. As shown in FIG. 8, the body portion 311 extends in the third direction y. The body portion 311 bridges the gap between the first conductive layer 121 and the second conductive layer 122.

As shown in FIGS. 8 and 12, the first bonding portions 312 are individually bonded to the second electrodes 212 of the first semiconductor elements 21. Each of the first bonding portions 312 faces a corresponding one of the second electrodes 212 of the first semiconductor elements 21.

As shown in FIGS. 8 and 12, the first coupling portions 313 are connected to the body portion 311 and to the respective first bonding portions 312. The first coupling portions 313 are spaced apart from one another in the third direction y. As viewed in the third direction y, the first coupling portions 313 are each inclined away from the first mounting surface 121A of the first conductive layer 121 from the respective first bonding portions 312 toward the body portion 311.

As shown in FIGS. 8 and 11, the second bonding portion 314 is bonded to the second mounting surface 122A of the second conductive layer 122. The second bonding portion 314 faces the second mounting surface 122A. The second bonding portion 314 extends in the third direction y. A dimension of the second bonding portion 314 in the third direction y is equal to a dimension of the body portion 311 in the third direction y.

As shown in FIGS. 8 and 11, the second coupling portion 315 is connected to the body portion 311 and to the second bonding portion 314. As viewed in the third direction y, the second coupling portion 315 is inclined away from the second mounting surface 122A of the second conductive layer 122 from the second bonding portion 314 toward the body portion 311. A dimension of the second coupling portion 315 in the third direction y is equal to a dimension of the body portion 311 in the third direction y.

As shown in FIG. 12, a third bonding layer 39 is interposed between a second electrode 212 of a first semiconductor element 21 and a corresponding one of the first bonding portions 312. The third bonding layers 39 electrically bond the first bonding portions 312 and the respective second electrodes 212 of the first semiconductor elements 21. Each third bonding layer 39 is solder, for example. As shown in FIG. 11, a third bonding layer 39 is interposed between the second mounting surface 122A of the second conductive layer 122 and the second bonding portion 314. The third bonding layers 39 electrically bond the second mounting surface 122A and the second bonding portion 314.

As shown in FIGS. 7 and 13, the second conductive member 32 is electrically bonded to the second electrodes 212 of the second semiconductor elements 22 and the two second power terminals 14. Accordingly, the second electrodes 212 of the second semiconductor elements 22 are electrically connected to the second power terminals 14. The second conductive member 32 contains copper. The second conductive member 32 is a metal clip. As shown in FIG. 7, the second conductive member 32 includes two body portions 321, a plurality of third bonding portions 322, a plurality of third coupling portions 323, a plurality of intermediate portions 326, and a beam portion 327.

As shown in FIG. 7, the two body portions 321 are spaced apart from each other in the third direction y. The two body portions 321 each extend in the second direction x. As shown in FIG. 10, the two body portions 321 are disposed parallel to the first mounting surface 121A of the first conductive layer 121 and the second mounting surface 122A of the second conductive layer 122. The two body portions 321 are farther from the first mounting surface 121A and the second mounting surface 122A than the body portion 311 of the first conductive member 31.

As shown in FIG. 7, the intermediate portions 326 are spaced apart from each other in the third direction y, and located between the two body portions 321 in the third direction y. The intermediate portions 326 each extend in the second direction x. A dimension of each of the intermediate portions 326 in the second direction x is smaller than a dimension of each of the two body portions 321 in the second direction x.

As shown in FIG. 13, the third bonding portions 322 are individually bonded to the second electrodes 212 of the second semiconductor elements 22. Each of the third bonding portions 322 faces the fourth electrode 222 of a corresponding one of the second semiconductor elements 22.

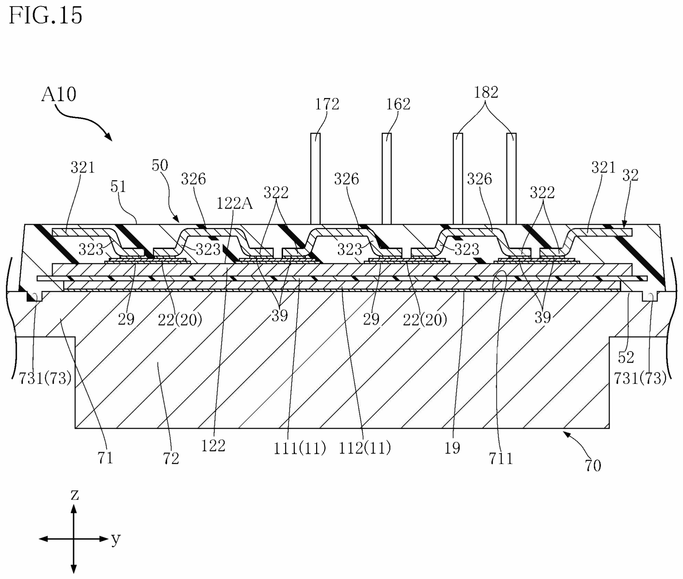

As shown in FIGS. 7 and 15, the third coupling portions 323 are connected to the respective third bonding portions 322 in the third direction y. Further, each of the third coupling portions 323 is connected to either one of the two body portions 321 or one of the intermediate portions 326. As viewed in the second direction x, each of the third coupling portions 323 is inclined away from the second mounting surface 122A of the second conductive layer 122 from one of the third bonding portions 322 toward one of the two body portions 321 or one of the intermediate portions 326.

As shown in FIG. 7, the beam portion 327 extends in the third direction y. As shown in FIG. 15, as viewed in the first direction z, the beam portion 327 includes regions overlapping with the respective first bonding portions 312 of the first conductive member 31. The beam portion 327 has two sides in the third direction y connected to the respective two body portions 321.

As shown in FIG. 13, a third bonding layer 39 is interposed between a fourth electrode 222 of a second semiconductor element 22 and a corresponding one of the third bonding portions 322. The third bonding layers 39 electrically bond the third bonding portions 322 and the respective fourth electrodes 222 of the second semiconductor elements 22. As shown in FIG. 10, a third bonding layer 39 is interposed between each of the two second power terminals 14 and a corresponding one of the two body portions 321. The third bonding layers 39 electrically bond the two second power terminals 14 and the respective two body portions 321.

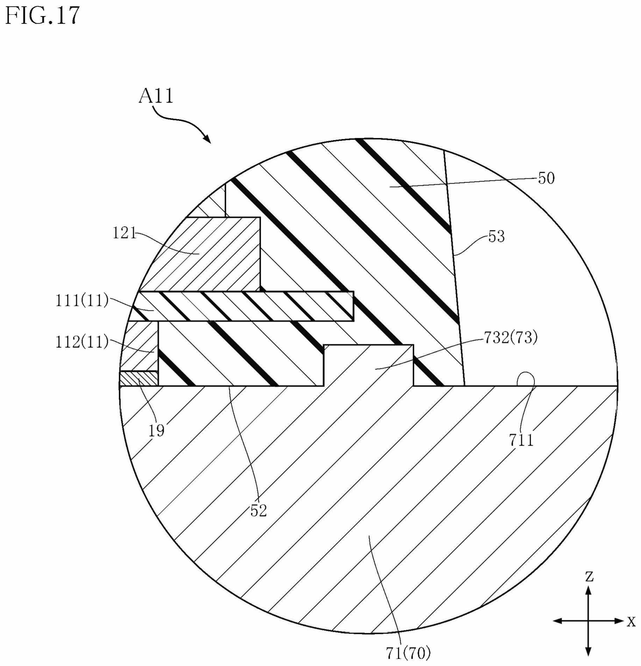

Next, with reference to FIG. 17, a semiconductor device A11 according to a first variation of the first embodiment of the present disclosure will be described. FIG. 17 corresponds to FIG. 16 illustrating the semiconductor device A10. The semiconductor device A11 differs from the semiconductor device A10 in the configuration of the engagement portion 73 of the heat sink 70.

As shown in FIG. 17, the engagement portion 73 includes a projection 732 that projects from the obverse surface 711 of the heat sink 70. The projection 732 is embedded in the sealing resin 50.

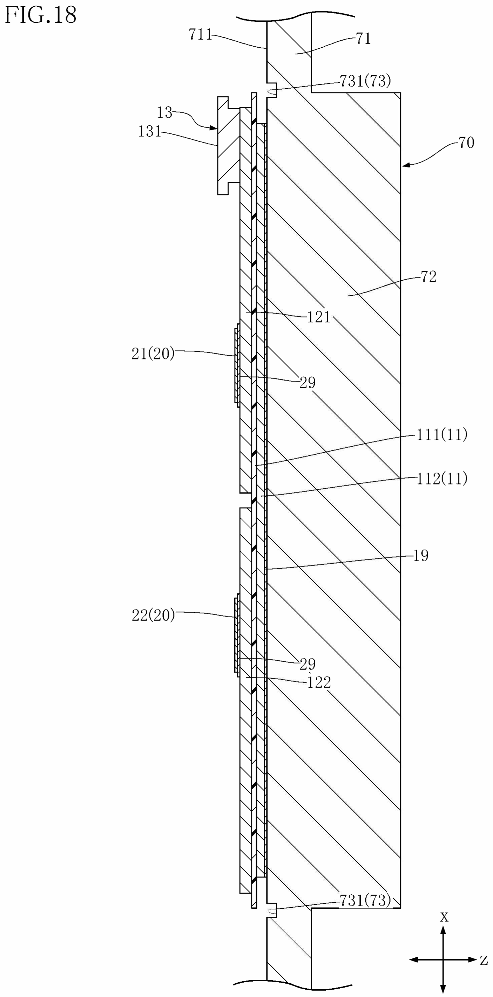

Next, with reference to FIGS. 18 to 20, an example of a method of manufacturing the semiconductor device A10 will be described. FIGS. 18 to 20 correspond to FIG. 11 illustrating the semiconductor device A10.

First, as shown in FIG. 18, a first step is performed of bonding each of the first conductive layer 121 and the second conductive layer 122 to the insulating layer 111 of the base material 11 located on one side in the first direction z. After completion of the first step, a second step and a third step are performed. In the second step, the metal layer 112 of the base material 11 is bonded to the base portion 71 of the heat sink 70 located on a side opposite the first conductive layer 121 and the second conductive layer 122 with respect to the base material 11 via the first bonding layer 19. In the third step, the first power terminal 13, the two second power terminals 14, and the two third power terminals 15 are disposed on the insulating layer 111, and each of the semiconductor elements 20 is electrically bonded to either the first conductive layer 121 or the second conductive layer 122 via a corresponding one of the second bonding layers 29. In the present manufacturing method, the second step and the third step are collectively performed through solid-state diffusion. Accordingly, each of the first bonding layer 19 and second bonding layers 29 is a minute metal layer formed at the bonding interface through solid-state diffusion.

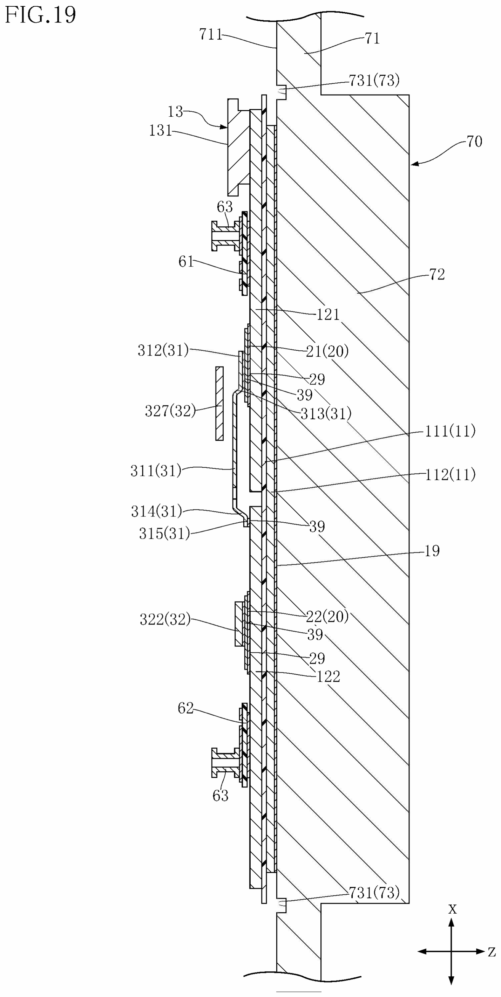

Next, as shown in FIG. 19, the first conductive member 31 is electrically bonded to the first semiconductor elements 21 and to the second conductive layer 122 via third bonding layers 39. The second conductive member 32 is electrically bonded to the second semiconductor elements 22 and to the two second power terminals 14 via third bonding layers 39. Further, the first wiring 61 is bonded to the first conductive layer 121 via a corresponding one of the third bonding layers 39. The second wiring 62 is bonded to the second conductive layer 122 via a corresponding one of the third bonding layers 39.

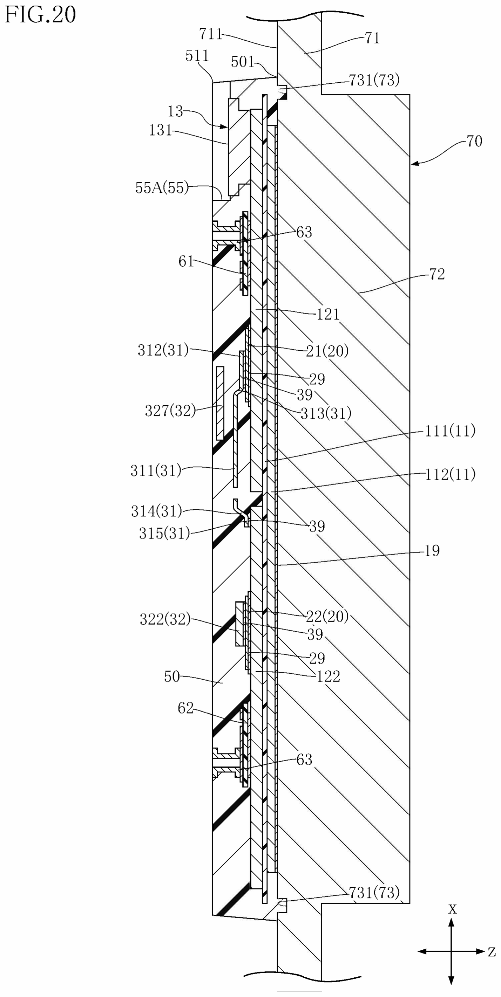

Next, as shown in FIG. 20, the sealing resin 50 is formed to cover the first conductive layer 121, the second conductive layer 122, the semiconductor elements 20, the first conductive member 31, and the second conductive member 32. The sealing resin 50 is formed by transfer molding. A fourth step is performed after completion of each of the first step, the second step, and the third step. In the fourth step, the first power terminal 13, the two second power terminals 14, and the two third power terminals 15 are left exposed from the sealing resin 50 such that each of these terminals is surrounded by the peripheral edge 501 of the sealing resin 50 as viewed in the first direction z. A glass transition temperature of the sealing resin 50 is set lower than a melting point of each of the first bonding layer 19 and the second bonding layers 29.

Finally, the first signal terminal 161, the second signal terminal 162, the third signal terminal 171, the fourth signal terminal 172, the two fifth signal terminals 181, and the two sixth signal terminals 182 are press-fitted individually into the respective sleeves 63. Through the above steps, the semiconductor device A10 is obtained.

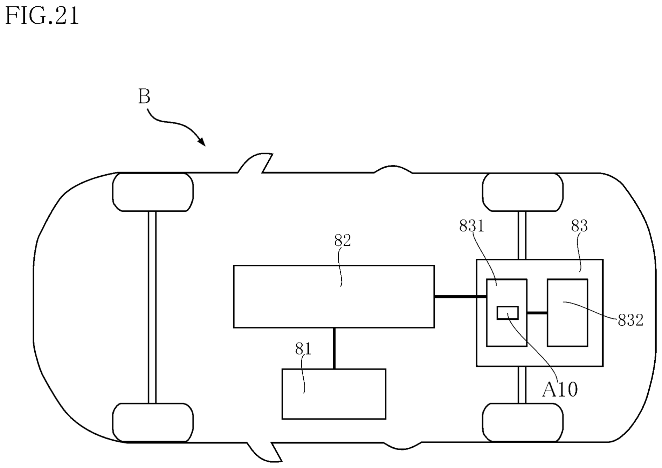

Next, with reference to FIG. 21, a vehicle B on which the semiconductor device A10 is mounted will be described. The vehicle B is, for example, an electric vehicle (EV).

As shown in FIG. 21, the vehicle B includes an on-board charger 81, a storage battery 82, and a driving system 83. Electric power is supplied to the on-board charger 81 wirelessly from a power-feeding facility installed outdoors (not shown). Alternatively, power may be supplied from the facility to the on-board charger 81 via a wired connection. The on-board charger 81 includes a step-up type DC-DC converter. A voltage of power supplied to the on-board charger 81 is increased by the converter and then supplied to the storage battery 82. The increased voltage is, for example, 600 V.

The driving system 83 drives the vehicle B. The driving system 83 includes an inverter 831 and a driving source 832. The semiconductor device A10 constitutes a part of the inverter 831. Electric power stored in the storage battery 82 is supplied to the inverter 831. The power supplied from the storage battery 82 to the inverter 831 is DC power. Alternatively, differently from the power system shown in FIG. 21, a step-up type DC-DC converter may further be provided between the storage battery 82 and the inverter 831. The inverter 831 converts the DC power into AC power. The inverter 831 including the semiconductor device A10 is electrically connected to the driving source 832. The driving source 832 includes an AC motor and a transmission. When the AC power converted by the inverter 831 is supplied to the driving source 832, the AC motor rotates and the rotation is transmitted to the transmission. The transmission reduces a rotational speed transmitted from the AC motor as appropriate, and rotates a drive shaft of the vehicle B. Thus, the vehicle B is driven. For driving the vehicle B, a rotational speed of the AC motor needs to be controlled as desired on the basis of information such as an amount of depression of an accelerator pedal. Therefore, the semiconductor device A10 in the inverter 831 is required to output AC power whose frequency is varied as appropriate in accordance with a required rotational speed of the AC motor.

Next, operative effects of the semiconductor device A10 will be described.

The semiconductor device A10 includes the heat sink 70, the base material 11 including the insulating layer 111, the first conductive layer 121, the first semiconductor element 21, the first power terminal 13, and the sealing resin 50. The first power terminal 13 is exposed from the sealing resin 50. As viewed in the first direction z, the first power terminal 13 is surrounded by the peripheral edge 501 of the sealing resin 50. Such a configuration prevents the first power terminal 13 from interfering with the molding die when the sealing resin 50 is formed to be integral with the heat sink 70 in manufacturing the semiconductor device A10. This can prevent defects on the surface of the sealing resin 50. Therefore, such a configuration improves a molded state of the sealing resin 50 in the semiconductor device A10 in which the heat sink 70 and the sealing resin 50 are integral with each other.

The first power terminal 13 is exposed from the top surface 51 of the sealing resin 50. As viewed in the first direction z, the first power terminal 13 is located inward of the peripheral edge 511 of the top surface 51. Such a configuration makes it possible to ensure a longer creepage distance (distance along the surface of the sealing resin 50) from the first power terminal 13 to the heat sink 70. Accordingly, it is possible to enhance the insulation withstand voltage of the semiconductor device A10.

The end surface 712 of the heat sink 70 is exposed from the sealing resin 50. Further, as viewed in the first direction z, the sealing resin 50 is located inward of the peripheral edge 701 of the heat sink 70. Such a configuration enables the molding die to be pressed against the heat sink 70 without a gap when the sealing resin 50 is formed to be integral with the heat sink 70 in manufacturing the semiconductor device A10. Accordingly, the molded state of the sealing resin 50 is further improved.

The semiconductor device A10 further includes the first bonding layer 19 bonding the obverse surface 711 of the heat sink 70 and the metal layer 112 of the base material 11. In addition, the semiconductor device A10 further includes a second bonding layer 29 electrically bonding the first conductive layer 121 and the first semiconductor element 21. A glass transition temperature of the sealing resin 50 is lower than a melting point of each of the first bonding layer 19 and the second bonding layer 29. Such a configuration prevents each of the first bonding layer 19 and second bonding layer 29 from melting even when the sealing resin 50 is thermally cured in forming the sealing resin 50 during manufacture of the semiconductor device A10.

The first bonding layer 19 is covered with the sealing resin 50. Such a configuration allows the first bonding layer 19 to be protected from external factors such as moisture.

The heat sink 70 is provided with the engagement portion 73 on the obverse surface 711. The sealing resin 50 is in contact with the engagement portion 73. In the semiconductor device A10, the engagement portion 73 includes the recess 731 recessed from the obverse surface 711. The sealing resin 50 is in contact with the inner circumferential surface 713 defining the recess 731. Such a configuration exhibits an anchoring effect in the sealing resin 50 with respect to the heat sink 70. Accordingly, it is possible to suppress the sealing resin 50 from peeling from the obverse surface 711.

The semiconductor device A10 further includes the first signal terminal 161 electrically connected to the first semiconductor element 21. The first signal terminal 161 projects from the top surface 51 of the sealing resin 50. Such a configuration makes it possible to ensure a longer creepage distance from the first signal terminal 161 to the heat sink 70.

### Second Embodiment:

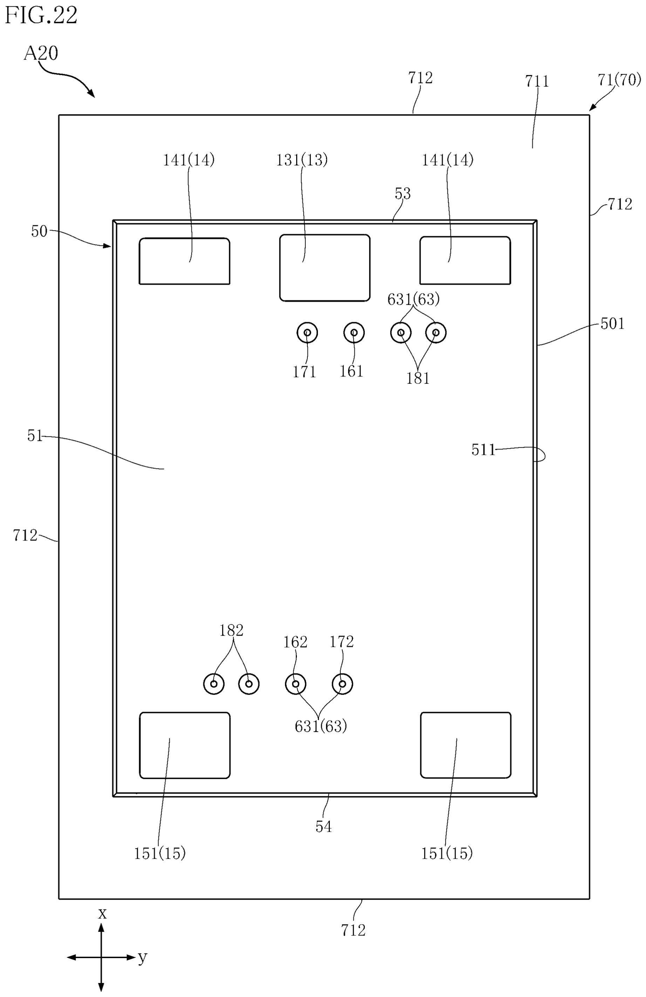

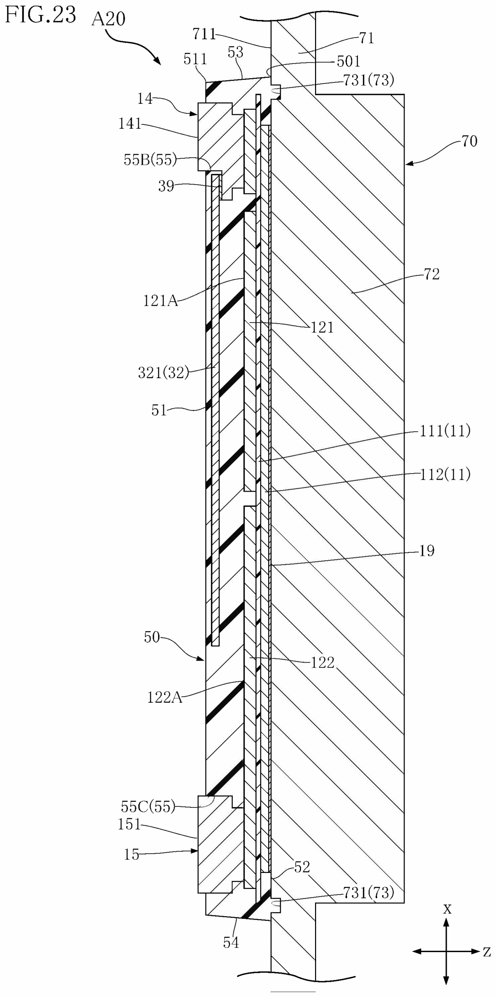

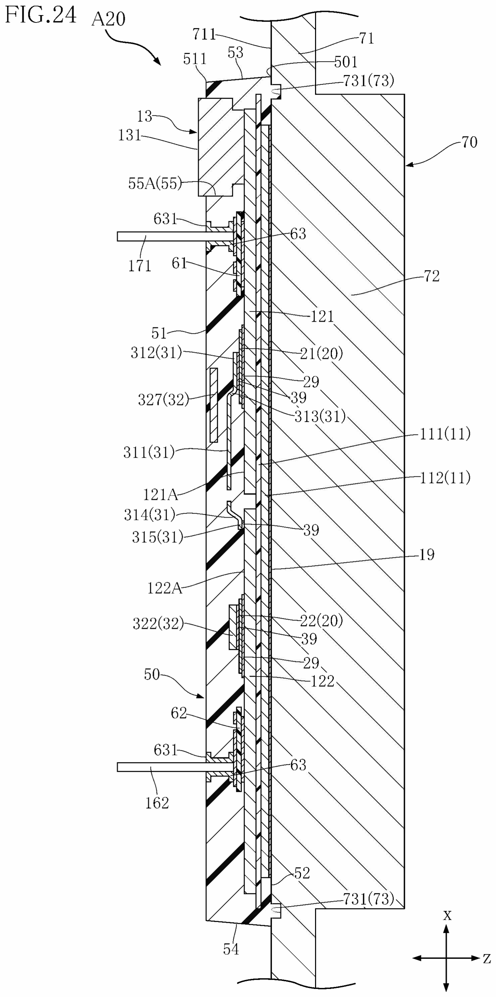

With reference to FIGS. 22 to 25, a semiconductor device A20 according to a second embodiment of the present disclosure will be described. Elements identical or similar to those of the semiconductor device A10 described above are marked with the same numerals in these figures, and redundant descriptions are omitted. Here, FIG. 23 corresponds to FIG. 10 illustrating the semiconductor device A10. FIG. 24 corresponds to FIG. 11 illustrating the semiconductor device A10.

The semiconductor device A20 differs from the semiconductor device A10 in the configurations of the first power terminal 13, the two second power terminals 14, the two third power terminals 15, and the sealing resin 50.

As shown in FIGS. 22 to 24, the first power terminal 13, the two second power terminals 14, and the two third power terminals 15 each project from the top surface 51 of the sealing resin 50. No recesses 55 are provided in the sealing resin 50. The first connection surface 131 of the first power terminal 13, the second connection surface 141 of each of the two second power terminals 14, and the third connection surface 151 of each of the two third power terminals 15 are located on a side opposite the bottom surface 52 of the sealing resin 50 with respect to the top surface 51 in the first direction z.

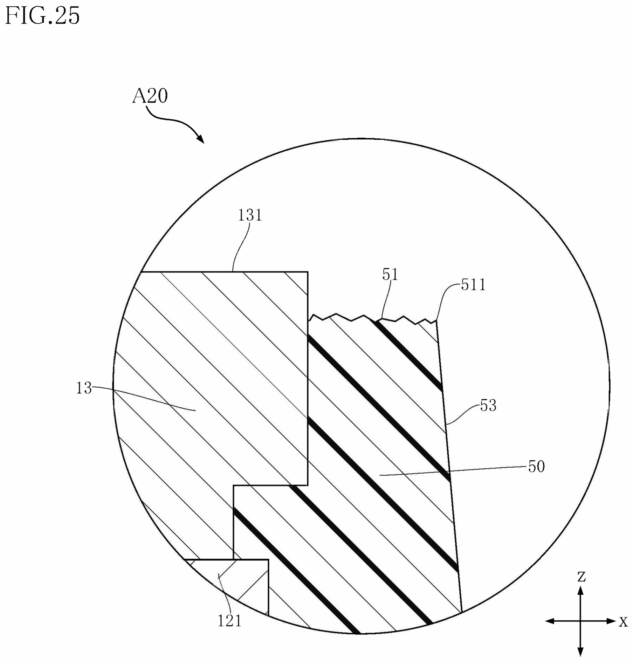

As shown in FIG. 25, the sealing resin 50 has a surface roughness greater than a surface roughness of the first side surface 53 of the sealing resin 50. This configuration is obtained by removing a portion of the sealing resin 50 on one side in the first direction z by a wet-blasting process or the like after forming the sealing resin 50.

Next, operative effects of the semiconductor device A20 will be described.

The semiconductor device A20 includes the heat sink 70, the base material 11 including the insulating layer 111, the first conductive layer 121, the first semiconductor element 21, the first power terminal 13, and the sealing resin 50. The first power terminal 13 is exposed from the sealing resin 50. As viewed in the first direction z, the first power terminal 13 is surrounded by the peripheral edge 501 of the sealing resin 50. Such a configuration improves a molded state of the sealing resin 50 even in the semiconductor device A20 in which the heat sink 70 and the sealing resin 50 are integral with each other. In addition, the semiconductor device A20 may have a configuration in common with the semiconductor device A10, thereby achieving the same effect as the semiconductor device A10.

In the semiconductor device A20, a part of the first power terminal 13 projects from the top surface 51 of the sealing resin 50. Such a configuration facilitates connection of an external connection member such as a bus bar to the first connection surface 131 of the first power terminal 13.

In the above case, the top surface 51 of the sealing resin 50 has a surface roughness greater than a surface roughness of the first side surface 53 of the sealing resin 50. Such a configuration allows a part of the first power terminal 13 to project from the top surface 51 while preventing the first power terminal 13 from interfering with the molding die when the sealing resin 50 is formed to be integral with the heat sink 70 in manufacturing the semiconductor device A20.

### Third Embodiment:

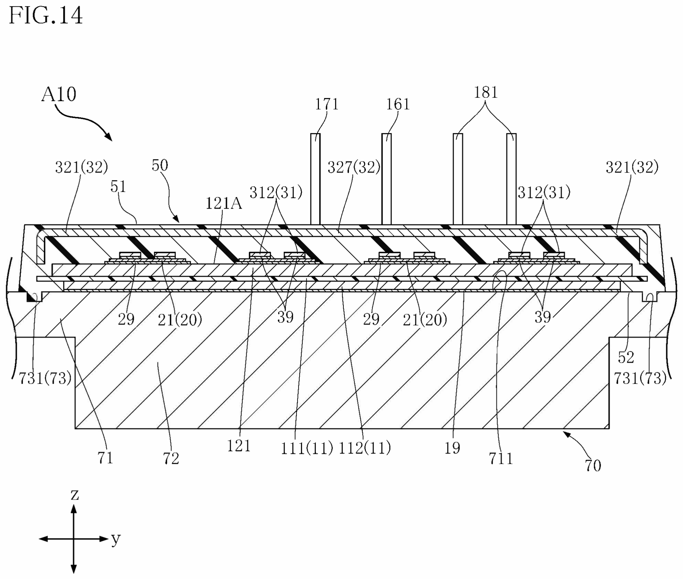

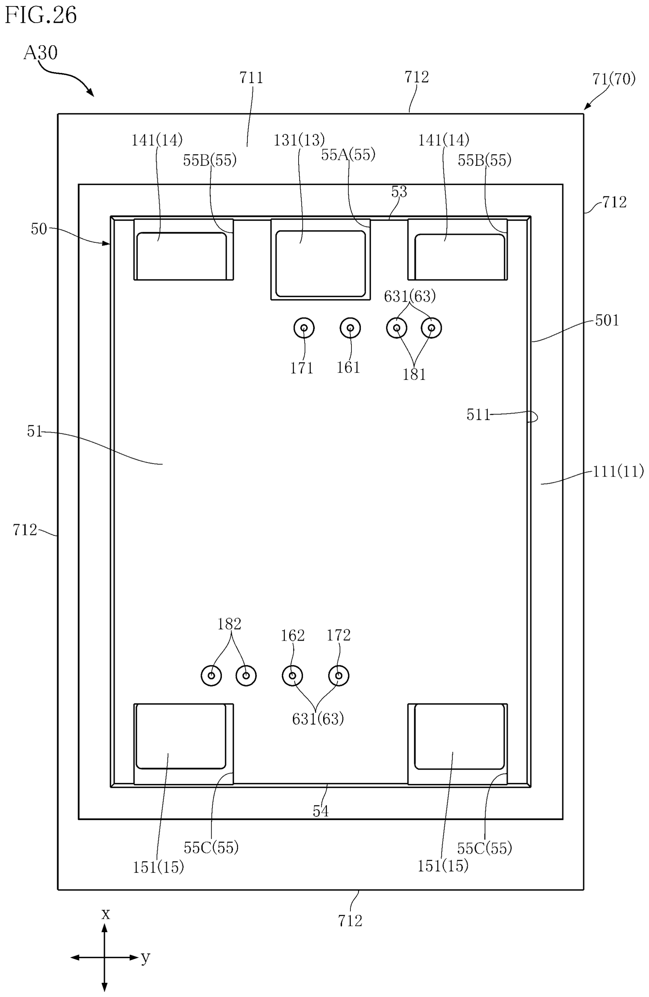

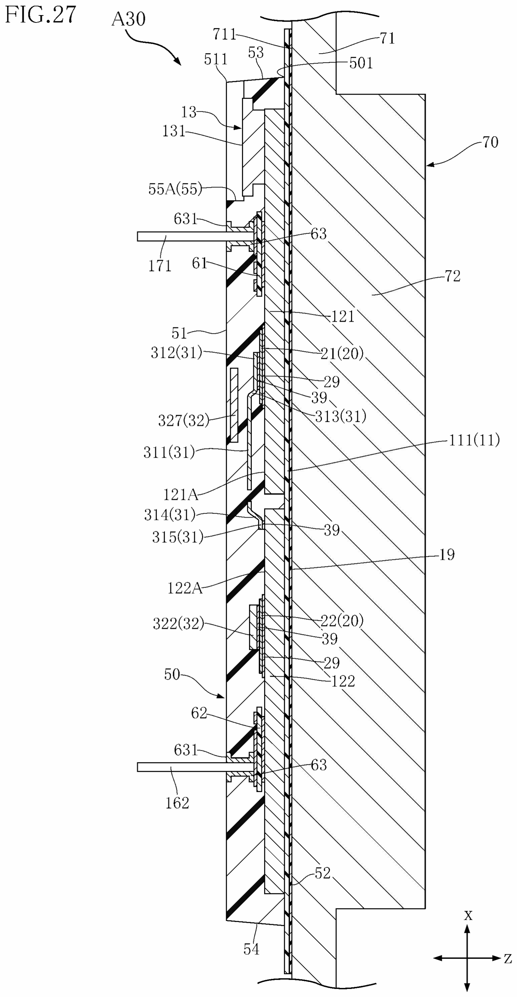

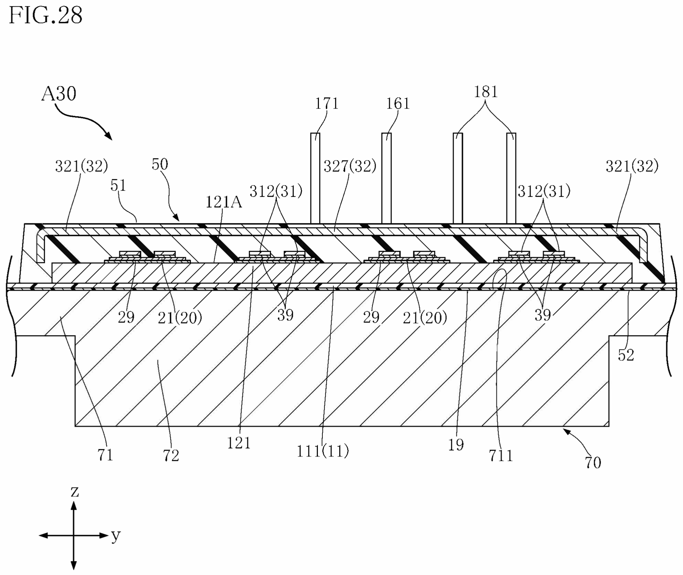

With reference to FIGS. 26 to 28, a semiconductor device A30 according to a third embodiment of the present disclosure will be described. Elements identical or similar to those of the semiconductor device A10 described above are marked with the same numerals in these figures, and redundant descriptions are omitted. Here, FIG. 27 corresponds to FIG. 11 illustrating the semiconductor device A10. FIG. 28 corresponds to FIG. 14 illustrating the semiconductor device A10.

The semiconductor device A30 differs from the semiconductor device A10 in the configuration of the base material 11.

As shown in FIGS. 27 and 28, the entirety of the base material 11 is the insulating layer 111. The bottom surface 52 of the sealing resin 50 is in contact with the base material 11. As shown in FIG. 26, the base material 11 extends beyond the peripheral edge 501 of the sealing resin 50.

In the semiconductor device A30, the first bonding layer 19 is, for example, configured from an adhesive including a resin material. Alternatively, a material of the first bonding layer 19 is not particularly limited as long as the insulating layer 111 can be directly bonded to the obverse surface 711 of the heat sink 70.

Next, operative effects of the semiconductor device A30 will be described.

The semiconductor device A30 includes the heat sink 70, the base material 11 including the insulating layer 111, the first conductive layer 121, the first semiconductor element 21, the first power terminal 13, and the sealing resin 50. The first power terminal 13 is exposed from the sealing resin 50. As viewed in the first direction z, the first power terminal 13 is surrounded by the peripheral edge 501 of the sealing resin 50. Such a configuration improves a molded state of the sealing resin 50 even in the semiconductor device A30 in which the heat sink 70 and the sealing resin 50 are integral with each other. In addition, the semiconductor device A30 may have a configuration in common with the semiconductor device A10, thereby achieving the same effect as the semiconductor device A10.

In the semiconductor device A30, the entirety of the base material 11 is the insulating layer 111. The bottom surface 52 of the sealing resin 50 is in contact with the base material 11. As viewed in the first direction z, the base material 11 extends beyond the peripheral edge 501 of the sealing resin 50. Such a configuration makes it possible to ensure a longer creepage distance (distance along respective surfaces of the sealing resin 50 and the base material 11) from the first power terminal 13 to the heat sink 70. Accordingly, it is possible to further enhance the insulation withstand voltage of the semiconductor device A30.

The semiconductor device according to present disclosure is not limited to the above-described embodiments. The specific configuration of each part of the semiconductor device according to present disclosure may be freely changed in design.

The present disclosure includes the configurations described in the following clauses.

### Clause 1.

A semiconductor device comprising:
a heat sink;
a base material mounted on the heat sink on one side in a first direction, the base material including an insulating layer;
a conductive layer bonded to the base material and located on a side opposite the heat sink with respect to the base material;
a semiconductor element bonded to the conductive layer;
a power terminal electrically connected to each of the conductive layer and the semiconductor element; and
a sealing resin covering the conductive layer and the semiconductor element,
wherein the power terminal is exposed from the sealing resin, and
the power terminal is surrounded by a peripheral edge of the sealing resin as viewed in the first direction.

### Clause 2.

The semiconductor device according to clause 1, wherein the sealing resin includes a top surface facing a side on which the conductive layer is located with respect to the base material, and
the power terminal is exposed from the top surface.

### Clause 3.

The semiconductor device according to clause 2, wherein the power terminal is disposed on the base material, and
the power terminal is located inward of a peripheral edge of the top surface as viewed in the first direction.

### Clause 4.

The semiconductor device according to clause 3, wherein the heat sink includes an obverse surface on which the base material is mounted, and
the sealing resin is in contact with the obverse surface.

### Clause 5.

The semiconductor device according to clause 4, wherein the heat sink includes an end surface facing a direction orthogonal to the first direction, and
the end surface is exposed from the sealing resin.

### Clause 6.

The semiconductor device according to clause 5, wherein the sealing resin is located inward of a peripheral edge of the heat sink as viewed in the first direction.

### Clause 7.

The semiconductor device according to clause 6, wherein the base material includes a metal layer bonded to the obverse surface, and the insulating layer laminated on the metal layer,
the conductive layer is bonded to the insulating layer, and
the insulating layer is covered with the sealing resin.

### Clause 8.

The semiconductor device according to clause 7, further comprising a first bonding layer bonding the obverse surface and the metal layer,
wherein each of the metal layer and the first bonding layer is covered with the sealing resin.

### Clause 9.

The semiconductor device according to clause 8, further comprising a second bonding layer electrically bonding the conductive layer and the semiconductor element,
wherein a glass transition temperature of the sealing resin is lower than a melting point of each of the first bonding layer and the second bonding layer.

### Clause 10.

The semiconductor device according to clause 9, wherein the heat sink is provided with an engagement portion on the obverse surface, and
the sealing resin is in contact with the engagement portion.

### Clause 11.

The semiconductor device according to clause 10, wherein the engagement portion includes a recess recessed from the obverse surface,
the heat sink includes an inner circumferential surface connected to the obverse surface and defining the recess, and
the sealing resin is in contact with the inner circumferential surface.

### Clause 12.

The semiconductor device according to clause 9, wherein a part of the power terminal projects from the top surface.

### Clause 13.

The semiconductor device according to clause 12, wherein the sealing resin includes a side surface facing a direction orthogonal to the first direction, and
the top surface has a surface roughness greater than a surface roughness of the side surface.

### Clause 14.

The semiconductor device according to clause 3, wherein an entirety of the base material is the insulating layer,
the sealing resin is in contact with the base material, and
the base material extends beyond a peripheral edge of the sealing resin as viewed in the first direction.

### Clause 15.

The semiconductor device according to any one of clauses 7 to 13, further comprising a signal terminal electrically connected to the semiconductor element,
wherein a part of the signal terminal projects from the top surface.

### Clause 16.

The semiconductor device according to clause 15, wherein the heat sink includes a base portion including the obverse surface and the end surface, and a heat radiating portion connected to the base portion, and
the heat radiating portion projects from the base portion on a side opposite the obverse surface in the first direction.

### Clause 17.

A vehicle comprising:
a driving source; and
the semiconductor device according to clause 15,
wherein the semiconductor device is electrically connected to the driving source.

### Clause 18.

A method of manufacturing a semiconductor device comprising:
a first step of bonding a conductive layer to a base material on one side in a first direction, the base material including an insulating layer;
a second step of bonding the base material to a heat sink located on a side opposite the conductive layer with respect to the base material;
a third step of disposing a power terminal on the base material and bonding a semiconductor element to the conductive layer; and
a fourth step of forming a sealing resin to cover the conductive layer and the semiconductor element,
wherein the fourth step is performed after completion of each of the first, second, and third steps, and
in the fourth step, the power terminal is left exposed from the sealing resin, the power terminal being surrounded by a peripheral edge of the sealing resin as viewed in the first direction.

### Clause 19.

The method according to clause 18, wherein, in the second step, the base material is bonded to the heat sink via a first bonding layer,
in the third step, the semiconductor element is bonded to the conductive layer via a second bonding layer, and
a glass transition temperature of the sealing resin is lower than a melting point of each of the first bonding layer and the second bonding layer.

### REFERENCE NUMERALS

A10, A20, A30: Semiconductor Device B1: Vehicle
11: Base Material 111: Insulating Layer
111A: Peripheral Edge 112: Metal Layer
121: First Conductive Layer 121A: First Mounting Surface
122: Second Conductive Layer 122A: Second Mounting Surface
13: First Power Terminal 131: First Connection Surface
14: Second Power Terminal 141: Second Connection Surface
15: Third Power Terminal 151: Third Connection Surface
161: First Signal Terminal 162: Second Signal Terminal
171: Third Signal Terminal 172: Fourth Signal Terminal
181: Fifth Signal Terminal 182: Sixth Signal Terminal
19: First Bonding Layer 20: Semiconductor Element
21: First Semiconductor Element 211: First Electrode
212: Second Electrode 213: First Gate Electrode
214: First Detection Electrode 22: Second Semiconductor Element
221: Third Electrode 222: Fourth Electrode
223: Second Gate Electrode 224: Second Detection Electrode
23: Thermistor 29: Second Bonding Layer
31: First Conductive Member 311: Main Body Portion
312: First Bonding Portion 313: First Coupling Portion
314: Second Bonding Portion 315: Second Coupling Portion
32: Second Conductive Member 321: Main Body Portion
322: Third Bonding Portion 323: Third Coupling portion
324: Fourth Bonding Portion 325: Fourth Coupling portion
326: Intermediate Portion 327: Beam Portion
41 to 47: First to Seventh Wire 50: Sealing Resin
501: Peripheral Edge 51: Top Surface
52: Bottom Surface 53: First Side Surface
54: Second Side Surface 55: Recess
55A to 55C: First to Third Recess 61: First Wiring
611: First Mounting Layer 612: First Metal Layer
613: First Gate Wiring Layer 614: First Detection Wiring Layer
615: First Temperature Detection Wiring Layer
616: Second Detection Wiring Layer
62: Second Wiring 621: Second Mounting Layer
622: Second Metal Layer 623: Second Gate Wiring Layer
624: Third Detection Wiring Layer
625: Second Temperature Detection Wiring Layer
626: Fourth Detection Wiring Layer 63: Sleeve
631: End Surface 70: Heat Sink
701: Peripheral Edge 71: Base Portion
711: Obverse Surface 712: End Surface
713: Inner Circumferential Surface 72: Heat Radiating Portion
73: Engagement Portion 731: Recess
732: Projection 81: On-Board Charger
82: Storage Battery 83: Driving System
831: Inverter 832: Driving Source
z: First Direction x: Second Direction y: Third Direction

## Claims

1. A semiconductor device comprising:
a heat sink;
a base material mounted on the heat sink on one side in a first direction, the base material including an insulating layer;
a conductive layer bonded to the base material and located on a side opposite the heat sink with respect to the base material;
a semiconductor element bonded to the conductive layer;
a power terminal electrically connected to each of the conductive layer and the semiconductor element; and
a sealing resin covering the conductive layer and the semiconductor element,
wherein the power terminal is exposed from the sealing resin, and
the power terminal is surrounded by a peripheral edge of the sealing resin as viewed in the first direction.

2. The semiconductor device according to claim 1, wherein the sealing resin includes a top surface facing a side on which the conductive layer is located with respect to the base material, and
the power terminal is exposed from the top surface.

3. The semiconductor device according to claim 2, wherein the power terminal is disposed on the base material, and
the power terminal is located inward of a peripheral edge of the top surface as viewed in the first direction.

4. The semiconductor device according to claim 3, wherein the heat sink includes an obverse surface on which the base material is mounted, and
the sealing resin is in contact with the obverse surface.

5. The semiconductor device according to claim 4, wherein the heat sink includes an end surface facing a direction orthogonal to the first direction, and
the end surface is exposed from the sealing resin.

6. The semiconductor device according to claim 5, wherein the sealing resin is located inward of a peripheral edge of the heat sink as viewed in the first direction.

7. The semiconductor device according to claim 6, wherein the base material includes a metal layer bonded to the obverse surface, and the insulating layer laminated on the metal layer,
the conductive layer is bonded to the insulating layer, and
the insulating layer is covered with the sealing resin.

8. The semiconductor device according to claim 7, further comprising a first bonding layer bonding the obverse surface and the metal layer,
wherein each of the metal layer and the first bonding layer is covered with the sealing resin.

9. The semiconductor device according to claim 8, further comprising a second bonding layer electrically bonding the conductive layer and the semiconductor element,
wherein a glass transition temperature of the sealing resin is lower than a melting point of each of the first bonding layer and the second bonding layer.

10. The semiconductor device according to claim 9, wherein the heat sink is provided with an engagement portion on the obverse surface, and
the sealing resin is in contact with the engagement portion.

11. The semiconductor device according to claim 10, wherein the engagement portion includes a recess recessed from the obverse surface,
the heat sink includes an inner circumferential surface connected to the obverse surface and defining the recess, and
the sealing resin is in contact with the inner circumferential surface.

12. The semiconductor device according to claim 9, wherein a part of the power terminal projects from the top surface.

13. The semiconductor device according to claim 12, wherein the sealing resin includes a side surface facing a direction orthogonal to the first direction, and
the top surface has a surface roughness greater than a surface roughness of the side surface.

14. The semiconductor device according to claim 3, wherein an entirety of the base material is the insulating layer,
the sealing resin is in contact with the base material, and
the base material extends beyond a peripheral edge of the sealing resin as viewed in the first direction.

15. The semiconductor device according to any one of claims 7 to 13, further comprising a signal terminal electrically connected to the semiconductor element,
wherein a part of the signal terminal projects from the top surface.

16. The semiconductor device according to claim 15, wherein the heat sink includes a base portion including the obverse surface and the end surface, and a heat radiating portion connected to the base portion, and
the heat radiating portion projects from the base portion on a side opposite the obverse surface in the first direction.

17. A vehicle comprising:
a driving source; and
the semiconductor device according to claim 15,
wherein the semiconductor device is electrically connected to the driving source.

18. A method of manufacturing a semiconductor device comprising:
a first step of bonding a conductive layer to a base material on one side in a first direction, the base material including an insulating layer;
a second step of bonding the base material to a heat sink located on a side opposite the conductive layer with respect to the base material;
a third step of disposing a power terminal on the base material and bonding a semiconductor element to the conductive layer; and
a fourth step of forming a sealing resin to cover the conductive layer and the semiconductor element,
wherein the fourth step is performed after completion of each of the first, second, and third steps, and
in the fourth step, the power terminal is left exposed from the sealing resin, the power terminal being surrounded by a peripheral edge of the sealing resin as viewed in the first direction.

19. The method according to claim 18, wherein, in the second step, the base material is bonded to the heat sink via a first bonding layer,
in the third step, the semiconductor element is bonded to the conductive layer via a second bonding layer, and
a glass transition temperature of the sealing resin is lower than a melting point of each of the first bonding layer and the second bonding layer.
